# EUROPEAN PATENT APPLICATION

(11) **EP 4 507 476 A1**
(43) Date of publication of application: **12.02.2025**
(21) Application number: 24183730.1
(22) Date of filing: 21.06.2024
(51) Int. Cl.: H10K 59/122, H10K 59/80

(54) **DISPLAY DEVICE AND METHOD OF PROVIDING THE SAME**

(30) Priority: 09.08.2023 KR 20230104408
(71) Applicant: Samsung Display Co., Ltd., Yongin-si, Gyeonggi-do 17113 (KR)
(72) Inventor: SHIN, Hyun Eok, Yongin-si (KR); YANG, Su Kyoung, Yongin-si (KR); LEE, Dong Min, Yongin-si (KR); PARK, Joon Yong, Yongin-si (KR); SO, Byung Soo, Yongin-si (KR); CHUNG, Yung Bin, Yongin-si (KR)
(74) Representative: Marks & Clerk LLP

(57) **Abstract**

A display device includes a pixel electrode in a light emission area, a pixel defining layer which is on the pixel electrode and defines the light emission area, a light emitting layer and a common electrode on the pixel electrode, a bank on the pixel defining layer, the bank including a first bank layer defining a lower portion of a bank opening corresponding to the light emission area and a second bank layer which defines an upper portion of the bank opening and a tip of the bank, the tip including upper and lower surfaces of the second bank layer, a lower inorganic encapsulation layer which is on the bank and includes an inorganic pattern on the common electrode and facing and spaced apart from both the upper and lower surfaces of the tip, and an auxiliary pattern between the lower surface of the tip and the inorganic pattern.

## Description

### BACKGROUND

### 1. Field

The present disclosure relates to a display device and a method of providing (or fabricating) the same.

### 2. Description of the Related Art

As the information society develops, the demand for display devices for displaying images has increased and diversified. For example, display devices have been applied to various electronic devices such as smartphones, digital cameras, laptop computers, navigation devices, and smart televisions. The display devices may be flat panel display devices such as liquid crystal display devices, field emission display devices, or organic light emitting display devices. Among such flat panel display devices, a light emitting display device may display an image without a backlight unit providing light to a display panel since each of the pixels of the display panel includes light emitting elements that may self-emit light.

Display devices have been applied to eyeglasses-type devices for providing virtual reality and augmented reality. The display device is implemented in a very small size of two inches or less in order to be applied to the eyeglasses-type device.

### SUMMARY

When a relatively small display device is applied to an electronic device, the display device has high pixel integration degree in order to be implemented with high resolution. For example, the display device applied to an eyeglasses-like device may have a high pixel integration degree of 400 pixels per inch (PPI) or more. When the display device is implemented in the very small size but has the high pixel integration degree as described above, planar areas of emission areas in which light emitting elements are disposed are reduced. Thus, it may be difficult to implement light emitting elements separated from each other for each light emission area through a mask process.

Aspects of the present disclosure provide a display device in which light emitting elements separated from each other are respectively provided for each of plural emission areas, without a mask process.

Aspects of the present disclosure also provide a display device in which an emission deviation which may occur for each pixel (or light emission area) due to permeation of an etchant into light emitting elements in an etching process performed during processes for fabrication of the display device is reduced.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

Detailed contents of other embodiments are described in a detailed description and are illustrated in the drawings.

According to an embodiment of the disclosure, a display device includes a first pixel electrode disposed on a substrate, a pixel defining film disposed on the substrate and exposing the first pixel electrode, a first light emitting layer disposed on the first pixel electrode, a first common electrode disposed on the first light emitting layer, a first bank layer disposed on the pixel defining film, a second bank layer disposed on the first bank layer and having side surfaces protruding more than side surfaces of the first bank layer, a first inorganic layer disposed on the first common electrode and the second bank layer and spaced apart from an upper surface of the second bank layer, and a first auxiliary layer disposed between a lower surface of the second bank layer and the first inorganic layer.

The first auxiliary layer may be disposed on an upper surface of the first common electrode and the side surfaces of the first bank layer.

A thickness of the first auxiliary layer on the upper surface of the first common electrode and a thickness of the first auxiliary layer on the lower surface of the second bank layer may be different from each other.

The display device may further include an organic encapsulation layer disposed between the upper surface of the second bank layer and the first inorganic layer.

The first inorganic layer may include a first surface facing the upper surface of the second bank layer and a second surface facing the side surface of the second bank layer.

The first auxiliary layer may be disposed on the second surface of the first inorganic layer.

The first auxiliary layer may be disposed on the first surface of the first inorganic layer.

A thickness of the first auxiliary layer on the first surface of the first inorganic layer may be greater than a thickness of the first auxiliary layer on the lower surface of the second bank layer.

The second bank layer in an area overlapping the first light emitting layer in a thickness direction of the substrate may be in contact with the organic encapsulation layer.

The first auxiliary layer may include transparent conductive oxide (TCO).

One end and the other end of the first common electrode may overlap the second bank layer in a thickness direction of the substrate.

The display device may further include a second pixel electrode disposed on the substrate and spaced apart from the first pixel electrode, a second light emitting layer disposed on the second pixel electrode, a second common electrode disposed on the second light emitting layer and spaced apart from the first common electrode, and a second inorganic layer disposed on the second common electrode and the second bank layer and spaced apart from the first inorganic layer and the upper surface of the second bank layer.

According to an embodiment of the disclosure, a display device includes a first pixel electrode disposed on a substrate, a pixel defining film disposed on the substrate and exposing the first pixel electrode, a first light emitting layer disposed on the first pixel electrode, a first common electrode disposed on the first light emitting layer, a first bank layer disposed on the pixel defining film, a second bank layer disposed on the first bank layer and having side surfaces protruding more than side surfaces of the first bank layer, a first inorganic layer including a body portion disposed on the first common electrode and a wing portion disposed on the second bank layer, a first auxiliary layer disposed between the body portion of the first inorganic layer and the first common electrode, and an organic encapsulation layer disposed between the wing portion of the first inorganic layer and the second bank layer.

The first auxiliary layer may be disposed on the side surfaces of the first bank layer and a lower surface of the second bank layer.

The second bank layer in an area overlapping the wing portion of the first inorganic layer in a thickness direction of the substrate may be in contact with the organic encapsulation layer.

According to an embodiment of the disclosure, a method for fabrication of a display device includes preparing a plurality of pixel electrodes, a pixel defining film, a first bank layer, and a second bank layer on a substrate, the plurality of pixel electrodes being spaced apart from each other, the pixel defining film exposing the pixel electrodes, the first bank layer being disposed on the pixel defining film, and the second bank layer protruding from side surfaces of the first bank layer, forming a first light emitting layer on a first pixel electrode of the pixel electrodes and forming a first light emitting pattern layer on the second bank layer, forming a first common electrode on the first light emitting layer and forming a first electrode pattern layer on the first light emitting pattern layer, forming a first auxiliary material layer on an upper surface of the first common electrode, an upper surface of the first electrode pattern layer, and a lower surface of the second bank layer, forming a first inorganic material layer on the first auxiliary material layer, etching a portion of the first inorganic material layer, etching a portion of the first auxiliary material layer, and exposing the second bank layer by etching the first light emitting pattern layer and the first electrode pattern layer.

In the etching of the portion of the first inorganic material layer, the portion of the first inorganic material layer may be removed through a dry etching process, and in the etching of the portion of the first auxiliary material layer, the first auxiliary material layer may be removed through a wet etching process.

In the exposing of the second bank layer by etching the first light emitting pattern layer and the first electrode pattern layer, the first light emitting pattern layer and the first electrode pattern layer between the second bank layer and the first inorganic material layer may be removed.

The forming of the first light emitting layer on the first pixel electrode of the pixel electrodes and the forming of the first light emitting pattern layer on the second bank layer may include disconnecting a material deposited on the substrate by a protruding side surface of the second bank layer to separate the material into the first light emitting layer and the first light emitting pattern layer.

The method for fabrication of a display device may further include forming a second light emitting layer on a second pixel electrode of the pixel electrodes and forming a second light emitting pattern layer on the second bank layer and the first inorganic material layer, forming a second common electrode on the second light emitting layer and forming a second electrode pattern layer on the second light emitting pattern layer, forming a second auxiliary material layer on an upper surface of the second common electrode, an upper surface of the second electrode pattern layer, and the lower surface of the second bank layer, forming a second inorganic material layer on the second auxiliary material layer, and etching a portion of the second inorganic material layer, where in the forming of the second light emitting pattern layer on the second bank layer and the first inorganic material layer, a material deposited on the second bank layer may be disconnected by the first inorganic material layer to form the separated second light emitting pattern layer on the second bank layer and the first inorganic material layer.

At least some of the above and other features of the invention are set out in the claims.

With a display device and a method for fabrication thereof according to an embodiment, an auxiliary layer may be included between a lower surface of a second bank layer and a lower inorganic encapsulation layer to prevent a radical of an etchant from permeating between the second bank layer and the lower inorganic encapsulation layer in an etching process. Damage to light emitting elements due to the etchant or moisture is prevented, and thus, a luminance difference between the light emitting elements may be reduced.

The effects of the present disclosure are not limited to the aforementioned effects, and various other effects are included in the present specification.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to an embodiment;
FIG. 2 is a cross-sectional view of the display device of FIG. 1 viewed from the side;
FIG. 3 is an enlarged plan view illustrating an arrangement of light emitting elements, lower inorganic encapsulation layers, and a second bank layer of the display device according to an embodiment;
FIG. 4 is a cross-sectional view illustrating a portion of the display device according to an embodiment;
FIG. 5 is an enlarged cross-sectional view illustrating a first emission area, specifically, area A1 of FIG. 4;
FIG. 6 is an enlarged cross-sectional view of a display device according to an embodiment;
FIG. 7 is an enlarged cross-sectional view of a display device according to still an embodiment;
FIG. 8 is an enlarged cross-sectional view of a display device according to still an embodiment;
FIG. 9 is an enlarged cross-sectional view illustrating that an etchant permeates into a light emitting element when there is no auxiliary layer;
FIG. 10 is an enlarged cross-sectional view illustrating that penetration of an etchant is prevented through an auxiliary layer; and
FIGS. 11 to 23 are cross-sectional views illustrating processes in a method of providing the display device according to an embodiment.

### DETAILED DESCRIPTION

The invention will now be described more fully hereinafter with reference to the accompanying drawings, in which embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art. The same reference numbers indicate the same components throughout the specification. Within the Figures and the text of the disclosure, a reference number indicating a singular form of an element may also be used to reference a plurality of the singular element.

It will also be understood that when a layer is referred to as being related to another element such as being "on" another layer or substrate, it can be directly on the other layer or substrate, or intervening layers may also be present. In contrast, when a layer is referred to as being related to another element such as being "directly on" another layer or substrate, no intervening layer is present.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments will be described with reference to the accompanying drawings.

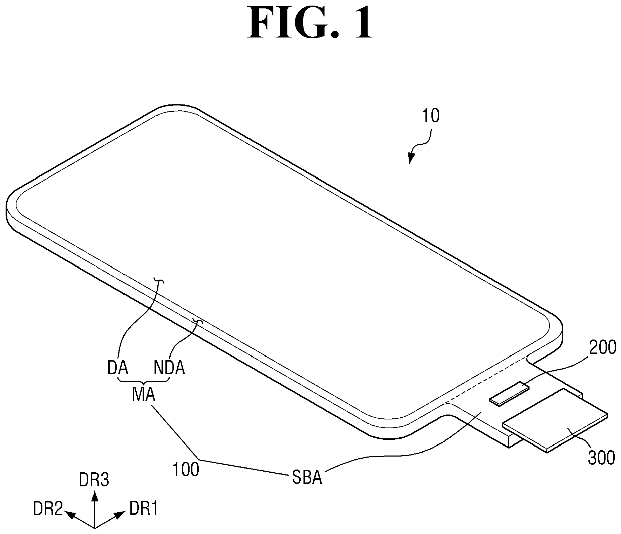

FIG. 1 is a perspective view illustrating a display device 10 according to an embodiment.

Referring to FIG. 1, a display device 10 according to an embodiment may be included in an electronic device to provide a screen for displaying an image (e.g., a display screen) on the electronic device. The electronic device may refer to all electronic devices which provide display screens. For example, televisions, laptop computers, monitors, billboards, the Internet of Things (IoT), mobile phones, smartphones, tablet personal computers (PCs), electronic watches, smart glasses, smart watches, watch phones, head mounted displays, mobile communication terminals, electronic notebooks, electronic books, portable multimedia players (PMPs), navigation devices, game machines, digital cameras, camcorders, and the like, which provide display screens, may be included in the electronic device.

A shape of the display device 10 may be variously changed. For example, the display device 10 may have a planar shape similar to a rectangular shape having short sides extended in a first direction DR1 and long sides extended in a second direction DR2 crossing the first direction DR1. A corner where the short side in the first direction DR1 and the long side in the second direction DR2 meet may be rounded with a curvature in the plan view, but is not limited thereto, and may also be right-angled. The shape of the display device 10 in plan view (e.g., a planar shape) is not limited to the rectangular shape, and may be a shape similar to other polygonal shapes, a circular shape, or an elliptical shape.

The display device 10 may include a display panel 100, a display driver 200, a circuit board 300, and a touch driver 400.

The display panel 100 may include a main area MA and a sub-area SBA.

The main area MA may include a display area DA including pixels displaying an image and a non-display area NDA which is adjacent to the display area DA. In an embodiment, the non-display area NDA may be disposed around the display area DA in the plan view. The display area DA may emit light from a plurality of emission areas or a plurality of opening areas (e.g., a light emission area provided in plural including a plurality of light emission areas). For example, the display panel 100 may include pixel circuits including switching elements, a pixel defining film defining the emission areas or the opening areas, and self-light emitting elements connected to the pixel circuit.

For example, the self-light emitting element as a light emitting element may include at least one of an organic light emitting diode (LED) including an organic light emitting layer, a quantum dot LED including a quantum dot light emitting layer, an inorganic LED including an inorganic semiconductor, and a micro LED, but is not limited thereto.

A plurality of pixels, a plurality of scan lines, a plurality of data lines, and a plurality of power lines may be disposed in the display area DA. Each of the plurality of pixels may be defined as a minimum unit emitting light, display an image, etc., and each of the self-light emitting elements described above may be each of the pixels. The plurality of scan lines as signal lines may supply scan signals as electrical signals received from a scan driver to the plurality of pixels. The plurality of data lines as signal lines may supply data voltages as electrical signals received from the display driver 200 to the plurality of pixels. The plurality of power lines as signal lines may supply source voltages as electrical signals received from the display driver 200 to the plurality of pixels.

The non-display area NDA may be an area (e.g., a planar area) outside the display area DA, such as to be closer to an outer edge of the display device 10 than the display area DA. The non-display area NDA may be defined as an edge area of the main area MA of the display panel 100. The non-display area NDA may include the scan driver supplying the scan signals to the scan lines, and fan-out lines connecting the display driver 200 and the display area DA to each other.

The sub-area SBA may be an area extending from one side of the main area MA. The sub-area SBA may include a flexible material which may be bent, folded, and rolled. For example, when the display device 10 is bent at the sub-area SBA, the sub-area SBA may overlap the main area MA in a thickness direction (e.g., a third direction DR3). That is, a thickness of the display device 10 and various components or layers thereof may be defined along the third direction DR3 which intersects the plane defined by the first direction DR1 and the second direction DR2 crossing each other. The sub-area SBA may include the display driver 200 and pad parts connected to the circuit board 300. In another embodiment, the sub-area SBA may be omitted, and the display driver 200 and the pad parts may be disposed in the non-display area NDA. In an embodiment, the sub-area SBA may be a portion of the non-display area NDA.

The display driver 200 may output signals and voltages for driving the display panel 100. The display driver 200 may supply the data voltages to the data lines. The display driver 200 may supply the source voltages to the power lines and supply scan control signals to the scan driver. The display driver 200 may be formed (or provided) as an integrated circuit (IC) and mounted on the display panel 100 in a chip on glass (COG) manner, a chip on plastic (COP) manner, or an ultrasonic bonding manner. As an example, the display driver 200 may be disposed in the sub-area SBA, and may overlap the main area MA in the thickness direction (e.g., a third direction DR3) by bending of the display device 10 at the sub-area SBA. As another example, the display driver 200 may be mounted on the circuit board 300.

The circuit board 300 may be attached to the display panel 100 at the pad parts of the display panel 100 such as by using an anisotropic conductive film (ACF). Lead lines of the circuit board 300 may be electrically connected to the display panel 100 at the pad parts of the display panel 100. The circuit board 300 may be a flexible printed circuit board, a printed circuit board, or a flexible film such as a chip on film.

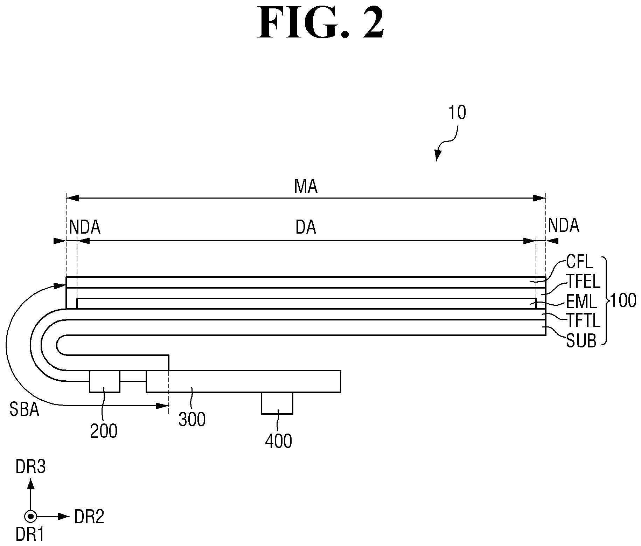

FIG. 2 is a cross-sectional view of the display device 10 of FIG. 1 viewed from the side. Specifically, FIG. 2 illustrates a side surface of the display device 10 of FIG. 1 in a state in which the display device is folded. The display device 10 and various components or layers thereof may be bendable, foldable, rollable, etc., such as to be deformed together with each other.

Referring to FIG. 2, the display panel 100 may include a substrate SUB, a thin film transistor layer TFTL as a circuit layer, a light emitting element layer EML, a thin film encapsulation layer TFEL as an encapsulation layer, and a color filter layer CFL.

The substrate SUB may be a base substrate or a base member. The substrate SUB may be a flexible substrate which may be bent, folded, and rolled. For example, the substrate SUB may include a polymer resin such as polyimide (PI), but is not limited thereto. In another embodiment, the substrate SUB may include a glass material or a metal material.

The thin film transistor layer TFTL may be disposed on the substrate SUB. The thin film transistor layer TFTL may include a plurality of thin film transistors constituting pixel circuits of pixels. The thin film transistor layer TFTL may further include scan lines, data lines, power lines, scan control lines, fan-out lines connecting the display driver 200 and the data lines to each other, and lead lines connecting the display driver 200 and the pad parts to each other. Each of the thin film transistors may include a semiconductor region, a source electrode, a drain electrode, and a gate electrode. For example, when the scan driver is formed on one side of the non-display area NDA of the display panel 100, the scan driver may include thin film transistors.

The thin film transistor layer TFTL may be disposed in the display area DA, the non-display area NDA, and the sub-area SBA. The thin film transistors of each of the pixels, the scan lines, the data lines, and the power lines of the thin film transistor layer TFTL may be disposed in the display area DA. The scan control lines and the fan-out lines of the thin film transistor layer TFTL may be disposed in the non-display area NDA. The lead lines of the thin film transistor layer TFTL may be disposed in the sub-area SBA.

The light emitting element layer EML may be disposed on the thin film transistor layer TFTL. The light emitting element layer EML may include a plurality of light emitting elements each including a first electrode, a second electrode and a light emitting layer to emit light, and a pixel defining film defining the pixels or the light emission areas thereof. The plurality of light emitting elements of the light emitting element layer EML may be disposed in the display area DA. The light emitting element layer EML may be electrically connected to the circuit layer (e.g., the thin-film transistor layer TFTL) to emit light, display an image with light, etc.

In an embodiment, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives a cathode voltage, holes and electrons may move to the organic light emitting layer through the hole transporting layer and the electron transporting layer, respectively, and may be combined with each other in the organic light emitting layer to emit light.

In another embodiment, the light emitting element may include a quantum dot light emitting diode including a quantum dot light emitting layer, an inorganic light emitting diode including an inorganic semiconductor, or a micro light emitting diode.

The thin film encapsulation layer TFEL may cover an upper surface and side surfaces of the light emitting element layer EML, and may protect the light emitting element layer EML. The thin film encapsulation layer TFEL may include at least one inorganic film and at least one organic film for encapsulating the light emitting element layer EML.

The color filter layer CFL may be disposed on the thin film encapsulation layer TFEL. The color filter layer CFL may include a plurality of color filters each corresponding to the plurality of emission areas. Each of the color filters may selectively transmit light of a specific wavelength therethrough and block or absorb light of other wavelengths. The color filter layer CFL may absorb some of light introduced from the outside of the display device 10 (e.g., external light) to reduce reflected light by external light. Accordingly, the color filter layer CFL may prevent distortion of colors due to external light reflection.

Since the color filter layer CFL is directly disposed on the thin film encapsulation layer TFEL, the display device 10 may not require a separate substrate for the color filter layer CFL. Accordingly, a thickness of the display device 10 may be relatively small.

In some embodiments, the display device 10 may further include an optical device which provides a function to the display device 10 as a functional component thereof. The optical device may emit or receive light of infrared, ultraviolet, and visible light bands. For example, the optical device may be an optical sensor sensing light incident on the display device 10, such as a proximity sensor, an illuminance sensor, a camera sensor, a fingerprint sensor, or an image sensor.

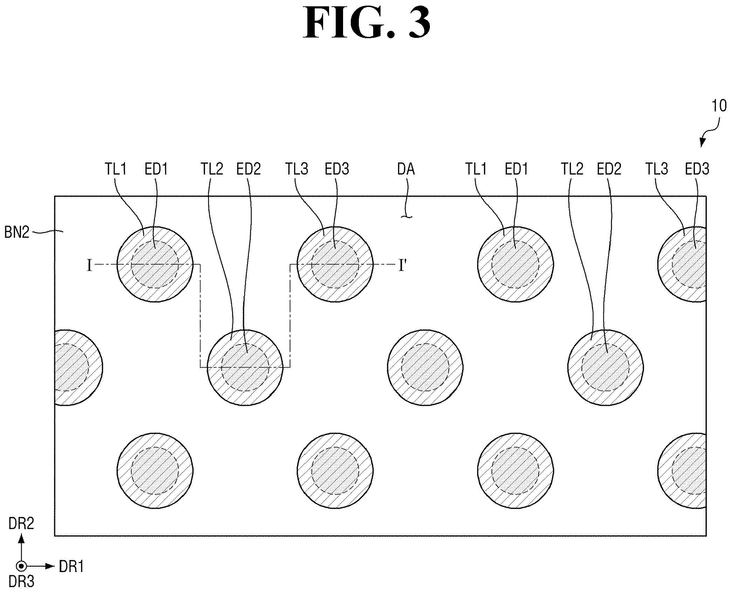

FIG. 3 is a plan view illustrating a portion of the display device 10 according to an embodiment. FIG. 3 is a plan view illustrating an arrangement of light emitting elements ED 1, ED2, and ED3, lower inorganic encapsulation layers TL1, TL2, and TL3 as patterns of a lower inorganic layer, and a second bank layer BN2 in the display area DA of the display device 10.

Referring to FIG. 3, the second bank layer BN2 may cover the display area DA, but expose portions (e.g., components, layers, etc.) of the display area DA to outside the second bank layer BN2. Openings (dotted line areas in FIG. 3) may be formed in exposed areas which are not covered with the second bank layer BN2, and the light emitting elements ED1, ED2, and ED3 may be disposed within the respective openings to be exposed outside the second bank layer BN2.

The lower inorganic encapsulation layers TL1, TL2, and TL3 may cover boundary portions of the openings on the second bank layer BN2, and may cover the light emitting elements ED1, ED2, and ED3 within the openings. Portions of the lower inorganic encapsulation layers TL1, TL2, and TL3 covering the boundary portions of the openings on the second bank layer BN2 may be referred to as wing portions.

It has been illustrated in FIG. 3 that the exposed areas which are not covered with the second bank layer BN2 have a circular shape in the plan view, but the exposed areas which are not covered with the second bank layer BN2 may have a polygonal shape in the plan view such as a triangular shape, a quadrangular shape, or a hexagonal shape. A shape of the lower inorganic encapsulation layers TL1, TL2, and TL3 covering the exposed areas and peripheral portions of the exposed areas may also be changed. Portions (wing portions) of the lower inorganic encapsulation layers TL1, TL2, and TL3 may be disposed at a level (or height) above the second bank layer BN2, and the light emitting elements ED1, ED2, and ED3 may be disposed at a level below the second bank layer BN2.

A plurality of light emitting elements ED1, ED2, and ED3 may be disposed in a PenTile^{™} type, for example, a diamond PenTile^{™} type, along the display area DA. For example, first light emitting elements ED1 and third light emitting elements ED3 may be disposed to be spaced apart from each other in the first direction DR1, and may be alternately disposed in the first direction DR1 and the second direction DR2. Second light emitting elements ED2 may be spaced apart from other adjacent second light emitting elements ED2 in the first direction DR1 and the second direction DR2. The second light emitting elements ED2 and the first light emitting elements ED1 or the second light emitting elements ED2 and the third light emitting elements ED3 may be alternately disposed along any one direction on a plane formed by the first direction DR1 and the second direction DR2, such as along an inclined direction. Shapes and arrangements of the exposed areas which are not covered by the second bank layer BN2 and the plurality of light emitting elements are not limited to those illustrated in FIG. 3.

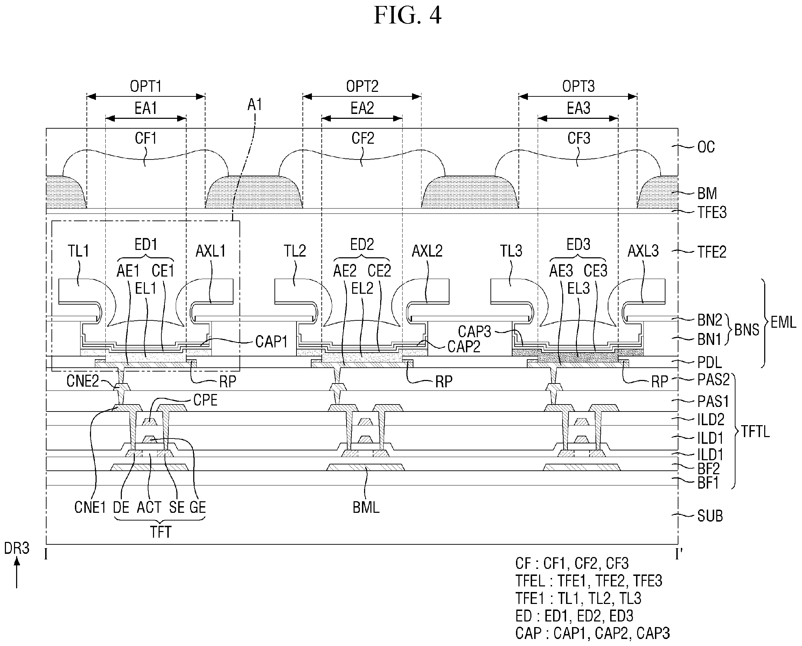

FIG. 4 is a cross-sectional view illustrating a portion of the display device 10 according to an embodiment. Specifically, FIG. 4 is a cross-sectional view taken along line I-I' of FIG. 3, and illustrates an organic encapsulation layer TFE2, an upper inorganic encapsulation layer TFE3, color filters CF1, CF2, and CF3, a light blocking layer BM, and an overcoat layer OC which are disposed above the plan view of FIG 3. FIG. 4 illustrates cross sections of the substrate SUB, the thin film transistor layer TFTL, the light emitting element layer EML, the thin film encapsulation layer TFEL, and the color filter layer CFL.

The thin film transistor layer TFTL may include a first buffer layer BF 1, a bottom metal layer BML, a second buffer layer BF2, thin film transistors TFT, a gate insulating layer GI, a first interlayer insulating layer ILD1, capacitor electrodes CPE, a second interlayer insulating layer ILD2, first connection electrodes CNE1, a first passivation layer PAS1, second connection electrodes CNE2, and a second passivation layer PAS2. One or more of the insulating layers mentioned above may be considered as "an insulating layer."

The first buffer layer BF1 may be disposed on the substrate SUB. The first buffer layer BF1 may include an inorganic film capable of preventing permeation of air or moisture. For example, the first buffer layer BF1 may include a plurality of inorganic films which are alternately stacked.

The bottom metal layer BML may be disposed on the first buffer layer BF1. For example, the bottom metal layer BML may be formed as a single layer or multiple layers made of any one of molybdenum (Mo), aluminium (Al), chromium (Cr), gold (Au), titanium (Ti), nickel (Ni), neodymium (Nd), copper (Cu), and alloys thereof.

The second buffer layer BF2 may cover the first buffer layer BF1 and the bottom metal layer BML. The second buffer layer BF2 may include an inorganic film capable of preventing permeation of air or moisture. For example, the second buffer layer BF2 may include a plurality of inorganic films which are alternately stacked.

The thin film transistor TFT may be disposed on the second buffer layer BF2, and may constitute a pixel circuit of each of the plurality of pixels. For example, the thin film transistor TFT may be a driving transistor or a switching transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the bottom metal layer BML and the gate electrode GE in the thickness direction DR3, and may be insulated from the gate electrode GE by the gate insulating layer GI. A material of the semiconductor layer ACT in portions of the semiconductor layer ACT may become conductors to form the source electrode SE and the drain electrode DE.

The gate electrode GE may be disposed on the gate insulating layer GI. The gate electrode GE may overlap the semiconductor layer ACT in the thickness direction DR3 with the gate insulating layer GI interposed therebetween.

The gate insulating layer GI may be disposed on the semiconductor layer ACT. For example, the gate insulating layer GI may cover the semiconductor layer ACT and the second buffer layer BF2, and may insulate the semiconductor layer ACT and the gate electrode GE from each other. The gate insulating layer GI may include (or define) contact holes through which the first connection electrodes CNE1 penetrate. That is, contact holes may be defined in the gate insulating layer GI. As used herein, a contact hole may penetrate completely through a thickness of a respective layer, such as to be open at both an upper surface and a lower surface which is opposite to the upper surface of the respective layer.

The first interlayer insulating layer ILD1 may cover the gate electrode GE and the gate insulating layer GI. The first interlayer insulating layer ILD1 may include contact holes through which the first connection electrodes CNE1 penetrate. The contact holes of the first interlayer insulating layer ILD1 may be connected to the contact holes of the gate insulating layer GI and contact holes of the second interlayer insulating layer ILD2.

The capacitor electrodes CPE may be disposed on the first interlayer insulating layer II,D1. The capacitor electrode CPE may overlap the gate electrode GE in the thickness direction DR3. The capacitor electrode CPE and the gate electrode GE may form capacitance.

The second interlayer insulating layer ILD2 may cover the capacitor electrodes CPE and the first interlayer insulating layer ILD1. The second interlayer insulating layer ILD2 may include contact holes through which the first connection electrodes CNE1 penetrate. The contact holes of the second interlayer insulating layer ILD2 may be connected to the contact holes of the first interlayer insulating layer ILD1 and the contact holes of the gate insulating layer GI.

The first connection electrodes CNE1 may be disposed on the second interlayer insulating layer ILD2. The first connection electrode CNE1 may electrically connect the drain electrode DE of the thin film transistor TFT and the second connection electrode CNE2 to each other. The first connection electrode CNE1 may be inserted into the contact holes formed in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include contact holes through which the second connection electrodes CNE2 penetrate.

The second connection electrodes CNE2 may be disposed on the first passivation layer PAS1. The second connection electrodes CNE2 may electrically connect the first connection electrodes CNE1 and pixel electrodes AE1, AE2, and AE3 of light emitting elements ED to each other. The second connection electrode CNE2 may be inserted into the contact hole formed in the first passivation layer PAS1 to be in contact with the first connection electrode CNE1. A first connection electrode CNE1 which contacts a second connection electrode CNE2 may form a connection electrode together with the second connection electrode CNE2.

The second passivation layer PAS2 may cover the second connection electrodes CNE2 and the first passivation layer PAS1. The second passivation layer PAS2 may include contact holes through which the pixel electrodes AE1, AE2, and AE3 of the light emitting elements ED penetrate.

The light emitting element layer EML may be disposed on the thin film transistor layer TFTL. The light emitting element layer EML may include light emitting elements ED, a pixel defining film PDL, capping layers CAP, and a bank structure BNS. The light emitting elements ED may include the pixel electrodes AE1, AE2, and AE3, light emitting layers EL1, EL2, and EL3, and common electrodes CE1, CE2, and CE3.

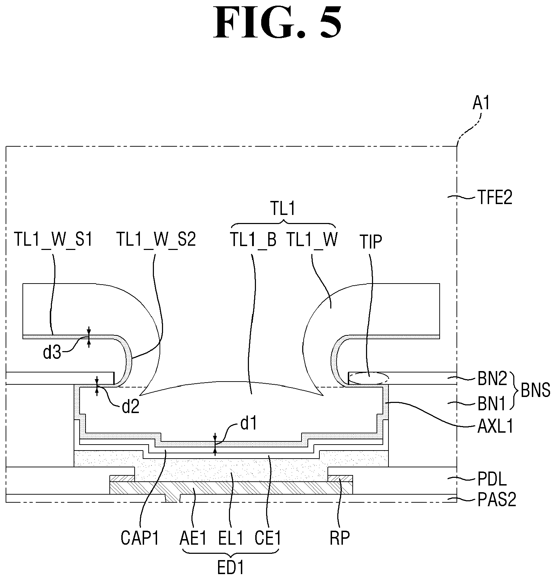

FIG. 5 is an enlarged view illustrating a first emission area EA1, specifically, area A1, of FIG. 4.

Referring to FIG. 5 in addition to FIG. 4, the display device 10 may include a plurality of emission areas EA1, EA2, and EA3 disposed in the display area DA. The emission areas EA1, EA2, and EA3 may include areas in which light is emitted from the light emitting elements ED1, ED2, and ED3 in which the pixel electrodes AE1, AE2, and AE3, the light emitting layers EL1, EL2, and EL3, and the common electrodes CE1, CE2, and CE3 are stacked, respectively, and passes to the color filter layer CFL in the third direction DR3. The emission areas EA1, EA2, and EA3 may include first emission areas EA1, second emission areas EA2, and third emission areas EA3 which are spaced apart from each other and emit light of the same or different colors.

In an embodiment, areas or sizes of the first to third emission areas EA1, EA2, and EA3 may be the same as each other. For example, in the display device 10, the first emission area EA1, the second emission area EA2, and the third emission area EA3 may have the same area in the plan view (e.g., a planar area). However, the present disclosure is not limited thereto. In the display device 10, areas or sizes of the first to third emission areas EA1, EA2, and EA3 may be different from each other. For example, an area of the second emission area EA2 may be greater than areas of the first emission area EA1 and the third emission area EA3, and an area of the third emission area EA3 may be greater than an area of the first emission area EA1. Intensities of the light emitted from the emission areas EA1, EA2, and EA3 may be changed depending on the areas of the emission areas EA1, EA2, and EA3, and a color feeling of a screen displayed on the display device 10 may be controlled by adjusting the areas of the emission area EA1, EA2, and EA3. In an embodiment of FIG. 4, it has been illustrated that the areas of the emission areas EA1, EA2, and EA3 are the same as each other, but the present disclosure is not limited thereto.

In the display device 10, one first emission area EA1, one second emission area EA2, and one third emission area EA3 disposed adjacent to each other may form one pixel group. One pixel group may include the emission areas EA1, EA2, and EA3 emitting light of different colors to express a white gradation. However, the present disclosure is not limited thereto, and a combination of the emission areas EA1, EA2, and EA3 constituting one pixel group may be variously modified depending on an arrangement of the emission areas EA1, EA2, and EA3, colors of the light emitted by the emission areas EA1, EA2, and EA3, and the like.

A plurality of openings (e.g., bank openings) formed in the bank structure BNS of the light emitting element layer EML are defined along a boundary of the emission areas EA1, EA2, and EA3. The bank openings are defined by material portions (e.g., solid portions) of the bank structure BNS.

The material portions of a first bank layer BN1 and a second bank layer BN2 of the bank structure BNS may have a planar shape which surrounds the emission areas EA1, EA2, and EA3. The bank openings may include the first to third emission areas EA1, EA2, and EA3. That is, a planar area of the bank openings may respectively include the planar areas of the emission areas EA1, EA2, and EA3. Each of the bank openings may have an upper thickness portion or upper volume corresponding to the first bank layer BN1 and a lower thickness portion or a lower volume corresponding to the second bank layer BN2. Together, solid portions of the first bank layer BN1 and the second bank layer BN2 may define a bank, and the bank together with the bank openings may define a bank layer (e.g., the bank structure BNS).

The display device 10 may include a plurality of light emitting elements ED1, ED2, and ED3 disposed in different emission areas EA1, EA2, and EA3. The light emitting elements ED1, ED2, and ED3 may include a first light emitting element ED1 disposed in the first emission area EA1, a second light emitting element ED2 disposed in the second emission area EA2, and a third light emitting element ED3 disposed in the third emission area EA3.

The light emitting elements ED1, ED2, and ED3 may include pixel electrodes AE1, AE2, and AE3, light emitting layers EL1, EL2, and EL3, and common electrodes CE1, CE2, and CE3, respectively, and the light emitting elements ED1, ED2, and ED3 disposed in the different emission areas EA1, EA2, and EA3 may emit light of different colors depending on materials of the light emitting layers EL1, EL2, and EL3, respectively. For example, the first light emitting element ED1 disposed in the first emission area EA1 may emit first light, which is red light, having a peak wavelength in the range of about 610 nanometers (nm) to about 650 nm, the second light emitting element ED2 disposed in the second emission area EA2 may emit second light, which is green light, having a peak wavelength in the range of about 510 nm to about 550 nm, and the third light emitting element ED3 disposed in the third emission area EA3 may emit third light, which is blue light, having a peak wavelength in the range of about 440 nm to about 480 nm.

The first to third emission areas EA1, EA2, and EA3 constituting one pixel may include the light emitting elements ED1, ED2, and ED3 emitting the light of the different colors to express a white gradation. Alternatively, the light emitting layers EL1, EL2, and EL3 may include two or more materials emitting the light of the different colors, such that one light emitting layer may emit mixed light. For example, the light emitting layers EL1, EL2, and EL3 may include both of a red light emitting material and a green light emitting material to emit yellow light or include all of a red light emitting material, a green light emitting material, and a blue light emitting material to emit white light.

The pixel electrodes AE1, AE2, and AE3 may be disposed on the second passivation layer PAS2. The pixel electrodes AE1, AE2, and AE3 may be disposed in the plurality of emission areas EA1, EA2, and EA3, respectively. The pixel electrodes AE1, AE2, and AE3 may include a first pixel electrode AE1 disposed in the first emission area EA1, a second pixel electrode AE2 disposed in the second emission area EA2, and a third pixel electrode AE3 disposed in the third emission area EA3. The first pixel electrode AE1, the second pixel electrode AE2, and the third pixel electrode AE3 may be disposed to be spaced apart from each other on the second passivation layer PAS2, respectively.

The pixel electrodes AE1, AE2, and AE3 may be electrically connected to the drain electrodes DE of the thin film transistors TFT through (or by) the first and second connection electrodes CNE1 and CNE2. Edges of the pixel electrodes AE1, AE2, and AE3 spaced apart from each other are covered by the pixel defining film PDL, such that the first to third pixel electrodes AE1, AE2, and AE3 may be insulated from each other.

The pixel electrodes AE1, AE2, and AE3 may include a transparent electrode material and/or a conductive metal material. The conductive metal material may be one or more of silver (Ag), copper (Cu), aluminium (Al), nickel (Ni), lanthanum (La), titanium (Ti), and titanium nitride (TiN). The transparent electrode material may be one or more of indium tin oxide (ITO), indium zinc oxide (IZO), and indium tin zinc oxide (ITZO). The pixel electrodes AE1, AE2, and AE3 may have a multilayer structure of the transparent electrode material and the conductive metal material.

The pixel defining film PDL may be disposed on the second passivation layer PAS2, residual patterns RP, and the pixel electrodes AE1, AE2, and AE3. The pixel defining film PDL may be entirely disposed on the second passivation layer PAS2 except for pixel openings corresponding to light emission areas at which to partially expose portions of upper surfaces of the pixel electrodes AE1, AE2, and AE3 to outside the pixel defining film PDL by covering side surfaces of the pixel electrodes AE1, AE2, and AE3 and the residual patterns RP. For example, at respective pixel openings, the pixel defining film PDL may expose the first pixel electrode AE1 in the first emission area EA1, and a first light emitting layer EL1 may be directly disposed on the exposed portion of the first pixel electrode AE1.

The pixel defining film PDL may include an inorganic insulating material. The pixel defining film PDL may include at least one of a silicon nitride layer, a silicon oxynitride layer, a silicon oxide layer, a titanium oxide layer, an aluminium oxide layer, a tantalum oxide layer, a hafnium oxide layer, a zinc oxide layer, and an amorphous silicon layer, but is not limited thereto.

According to an embodiment, the pixel defining film PDL may be disposed on the pixel electrodes AE1, AE2, and AE3, but may be spaced apart from the upper surfaces of the pixel electrodes AE1, AE2, and AE3. Within a pixel opening, for example, a portion of the pixel defining film PDL may not be in direct contact with the upper surfaces of the pixel electrodes AE1, AE2, and AE3 while partially overlapping the upper surfaces of the pixel electrodes AE1, AE2, and AE3 in the thickness direction DR3 of the substrate SUB, and the residual patterns RP may be disposed between the pixel defining film PDL and the pixel electrodes AE1, AE2, and AE3. However, at a region adjacent to the light emission area, a sidewall of the pixel defining film PDL may be in direct contact with the side surfaces of the pixel electrodes AE1, AE2, and AE3.

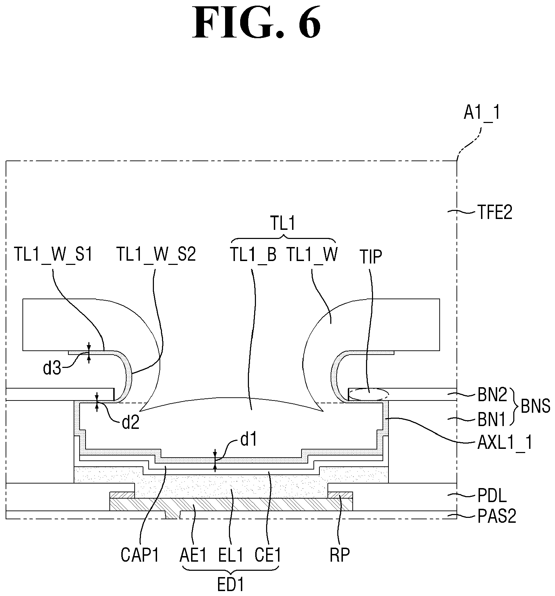

Side surfaces of the pixel defining film PDL define a pixel opening while side surfaces of the bank structure BNS define a bank opening. An opening may have thickness portions (or volume portions) which are arranged along the thickness direction and correspond to various material layers (e.g., the pixel defining film PDL, the first bank layer BN1, the second bank layer BN2, etc.). Referring to FIGS. 5 and 6, for example, the side surfaces of the pixel defining film PDL at an upper thickness portion may protrude further than side surfaces of the second bank layer BN2 at an upper thickness portion of the bank structure BNS, in a direction toward the emission areas EA1, EA2, and EA3.

The residual patterns RP may be disposed on edges of the pixel electrodes AE1, AE2, and AE3, respectively. The pixel defining film PDL may not be in direct contact with the upper surfaces of the pixel electrodes AE1, AE2, and AE3 due to the residual patterns RP respectively disposed therebetween within the pixel opening at a region adjacent to the light emission area.

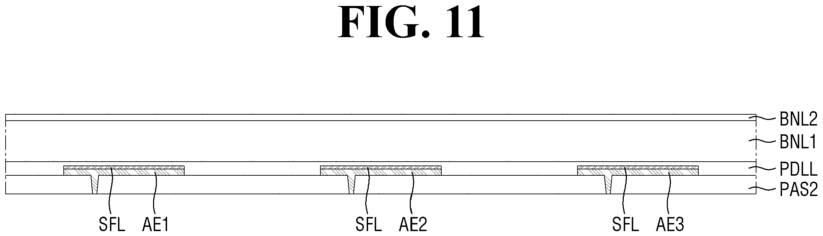

In an embodiment, the residual patterns RP may be formed by removing portions of sacrificial layers SFL (see FIG. 11) disposed on the pixel electrodes AE1, AE2, and AE3 in processes for fabrication of (or providing of) the display device 10. The residual patterns RP may include a metal or an oxide semiconductor material. Only a case where side surfaces of the residual patterns RP which are closest to the emission areas EA1, EA2, and EA3 are aligned with the side surfaces of the pixel defining film PDL has been illustrated in the drawings, but the present disclosure is not limited thereto. The side surfaces of the residual patterns RP which are closest to the various emission areas may protrude more than the side surfaces of the pixel defining film PDL which are closest to the emission areas EA1, EA2, and EA3 or may be recessed from the side surfaces of the pixel defining film PDL.

The light emitting layers EL1, EL2, and EL3 may be disposed on the pixel electrodes AE1, AE2, and AE3, respectively. The light emitting layers EL1, EL2, and EL3 may be organic light emitting layers made of (or including) an organic material, and may be formed on the pixel electrodes AE1, AE2, and AE3, respectively, through a deposition process. The light emitting layers EL1, EL2, and EL3 may have a multilayer structure, and a hole injection material, a hole transporting material, a light emitting material, an electron transporting material, and/or an electron injection material may constitute layers of the light emitting layers EL1, EL2, and EL3, respectively. When the thin film transistors TFT apply predetermined voltages to the pixel electrodes AE1, AE2, and AE3 of the light emitting elements ED1, ED2, and ED3 and the common electrodes CE1, CE2, and CE3 of the light emitting elements ED1, ED2, and ED3 receive a common voltage or a cathode voltage, holes and electrons may be injected and transported, respectively, and may be combined with each other in the light emitting layers EL1, EL2, and EL3 to emit light.

The light emitting layers EL1, EL2, and EL3 may include a first light emitting layer EL1, a second light emitting layer EL2, and a third light emitting layer EL3 each disposed in the different emission areas EA1, EA2, and EA3. The first light emitting layer EL1 may be disposed on the first pixel electrode AE1 in the first emission area EA1, the second light emitting layer EL2 may be disposed on the second pixel electrode AE2 in the second emission area EA2, and the third light emitting layer EL3 may be disposed on the third pixel electrode AE3 in the third emission area EA3. A plurality of light emitting layers EL1, EL2, and EL3 may emit light of different colors, respectively, or one light emitting layer EL1, EL2, or EL3 may emit mixed light. In an embodiment, the first light emitting layer EL1 may emit red light, the second light emitting layer EL2 may emit green light, and the third light emitting layer EL3 may emit blue light. In another embodiment, the first light emitting layer EL1 may emit yellow light, which is mixed light of red light and green light, and the second light emitting layer EL2 may emit blue light. In still another embodiment, the first light emitting layer EL1 may emit white light, which is mixed light of red light, green light, and blue light.

The light emitting layers EL1, EL2, and EL3 may be disposed on an upper surface of the pixel defining film PDL. In an embodiment, the light emitting layers EL1, EL2, and EL3 may be disposed in spaces or gaps respectively defined between upper surfaces of the pixel electrodes AE1, AE2, and AE3 and lower surfaces of the pixel defining film PDL which face each other in an area adjacent to respective emission areas. In an embodiment, the light emitting layers EL1, EL2, and EL3 may be in contact with each of the pixel defining film PDL, the residual patterns RP, and the upper surfaces of the pixel electrodes AE1, AE2, and AE3, which respectively form the spaces or gaps open to the respective emission areas.

The common electrodes CE1, CE2, and CE3 may be disposed on the light emitting layers EL1, EL2, and EL3, respectively. The common electrodes CE1, CE2, and CE3 may include a transparent conductive material to emit the light generated from the light emitting layers EL1, EL2, and EL3. The common electrodes CE1, CE2, and CE3 may receive a common voltage or a low potential voltage. When the pixel electrodes AE1, AE2, and AE3 receive voltages corresponding to data voltages and the common electrodes CE1, CE2, and CE3 receive the low potential voltage, potential differences are formed between the pixel electrodes AE1, AE2, and AE3 and the common electrodes CE1, CE2, and CE3, such that the light emitting layers EL1, EL2, and EL3 may emit the light.

The common electrodes CE1, CE2, and CE3 may include a first common electrode CE1, a second common electrode CE2, and a third common electrode CE3 each disposed in the different emission areas EA1, EA2, and EA3. The first common electrode CE1 may be disposed on the first light emitting layer EL1 in the first emission area EA1, the second common electrode CE2 may be disposed on the second light emitting layer EL2 in the second emission area EA2, and the third common electrode CE3 may be disposed on the third light emitting layer EL3 in the third emission area EA3. The first to third common electrodes CE1, CE2, and CE3 may be spaced apart from each other.

Capping layers CAP1, CAP2, and CAP3 as patterns within a capping layer may be disposed on the common electrodes CE1, CE2, and CE3, respectively. The capping layers CAP1, CAP2, and CAP3 may include an organic or inorganic insulating material and cover patterns disposed on the light emitting elements ED1, ED2, and ED3. The capping layers CAP1, CAP2, and CAP3 may prevent the light emitting elements ED1, ED2, and ED3 from being damaged by external air. In an embodiment, each of the capping layers CAP1, CAP2, and CAP3 may include an organic material such as α-NPD, NPB, TPD, m-MTDATA, Alq₃, LiF, and/or CuPc, or an inorganic material such as aluminium oxide, titanium oxide, tantalum oxide, hafnium oxide, zinc oxide, silicon oxide, silicon nitride, and/or silicon oxynitride.

The capping layers CAP1, CAP2, and CAP3 may include a first capping layer CAP1, a second capping layer CAP2, and a third capping layer CAP3 each disposed in a different emission area among the different emission areas EA1, EA2, and EA3. The first to third capping layers CAP1, CAP2, and CAP3 may be spaced apart from each other in a direction along the thin film transistor layer TFTL.

The display device 10 may include a plurality of bank structures BNS or banks which are disposed on the pixel defining film PDL. The bank structure BNS may have a structure in which bank layers BN1 and BN2 including different materials are sequentially stacked, may define the plurality of openings including a planar area of the emission areas EA1, EA2, and EA3, and may be disposed to overlap a light blocking layer BM to be described later. The light emitting elements ED1, ED2, and ED3 of the display device 10 may be disposed to overlap the openings of the bank structure BNS.

The bank structure BNS may include a first bank layer BN1 and a second bank layer BN2 which are sequentially stacked on the pixel defining film PDL.

The first bank layer BN1 may be disposed on the pixel defining film PDL. Inner side surfaces of the first bank layer BN1 which define a lower portion of a bank opening may be recessed from the inner side surfaces of the pixel defining film PDL which define a respective emission area, in a direction opposite to a direction toward the emission areas EA1, EA2, and EA3 (e.g., in a direction away from the respective emission area). The inner side surfaces of the first bank layer BN1 may be recessed from inner side surfaces of a second bank layer BN2 which define an upper portion of the bank opening, to be described later in the direction opposite to the direction toward the emission areas EA1, EA2, and EA3. The upper portion of the bank opening at the second bank layer BN2 and the lower portion of the bank opening at the first bank layer BN1, may together define a bank opening.

According to an embodiment, the first bank layer BN1 may include a metal material. In an embodiment, the first bank layer BN1 may include aluminium (Al) or an alloy of aluminium (Al).

In an embodiment, a thickness of the first bank layer BN1 may be in the range of 4000 angstroms (Å) to about 7000 Å. When the thickness of the first bank layer BN1 is in the above range, the light emitting layers EL1, EL2, and EL3 and the common electrodes CE1, CE2, and CE3 spaced apart from each other in a direction along the display panel 100 may be formed through deposition and etching processes rather than a mask process.

According to an embodiment, the common electrodes CE1, CE2, and CE3 may be in direct contact with the inner side surfaces of the first bank layer BN1. The common electrodes CE1, CE2, and CE3 of different light emitting elements ED1, ED2, and ED3 may be in direct contact with the first bank layer BN1, respectively, and the first bank layer BN1 may include the metal material, such that the common electrodes CE1, CE2, and CE3 may be electrically connected to each other through the first bank layer BN1.

The light emitting layers EL1, EL2, and EL3 may be in direct contact with the inner side surfaces of the first bank layer BN1. The light emitting layers EL1, EL2, and EL3 and the common electrodes CE1, CE2, and CE3 may contact the inner side surfaces at a contact area. The contact area may be a planar area defined in a plane including the third direction DR3 and another direction crossing the third direction like the first direction DR1 and/or the second direction DR2. A contact area between the common electrodes CE1, CE2, and CE3 and the inner side surfaces of the first bank layer BN1 may be greater than a contact area between the light emitting layers EL1, EL2, and EL3 and the inner side surfaces of the first bank layer BN1. The common electrodes CE1, CE2, and CE3 may be disposed to have a greater contact area than the light emitting layers EL1, EL2, and EL3 along the inner side surfaces of the first bank layer BN1 or may be extended further in the thickness direction from the pixel electrodes AE1, AE2, and AE3 disposed up to a greater height than the light emitting layers EL1, EL2, and EL3 along the inner side surfaces of the first bank layer BN1. Since the common electrodes CE1, CE2, and CE3 of the different light emitting elements ED1, ED2, and ED3 are electrically connected to each other through the first bank layer BN1, it may be advantageous that the common electrodes CE1, CE2, and CE3 are in contact with the first bank layer BN1 in a greater planar area.

The second bank layer BN2 may be disposed on the first bank layer BN1. The second bank layer BN2 may include or define tips TIP, which are areas protruding from the inner side surfaces of the first bank layer BN1 at each of the light emission areas. The side surfaces (e.g., inner side surfaces) of the second bank layer BN2 may protrude from the side surfaces (e.g., inner side surfaces) of the first bank layer BN1 in a direction toward the emission areas EA1, EA2, and EA3.

The side surfaces of the second bank layer BN2 have a shape in which they protrude further than the side surfaces of the first bank layer BN1 toward the emission areas EA1, EA2, and EA3. Accordingly, undercut structures of the first bank layer BN1 may be formed by the tips TIP of the second bank layer BN2 relative to the side surfaces of the first bank layer BN1.

In the display device 10 according to an embodiment, the bank structure BNS includes the tips TIP protruding toward the emission areas EA1, EA2, and EA3, and thus, the light emitting layers EL1, EL2, and EL3 and the common electrodes CE1, CE2, and CE3 may be formed through deposition and etching processes rather than the mask process. In addition, it is possible to form different layers individually in the different emission areas EA1, EA2, and EA3 even through a deposition process. For example, even though discrete patterns of the light emitting layers EL1, EL2, and EL3 and discrete patterns of the common electrodes CE1, CE2, and CE3 of the light emitting elements ED1, ED2, and ED3 are formed through a deposition process which does not use the mask, deposited material layers may be disconnected by the tips TIP of the second bank layer BN2 with the bank structure BNS interposed therebetween rather than being connected to each other at areas between the emission areas EA1, EA2, and EA3.

It is possible to form the different layers individually at patterns in the different emission areas EA1, EA2, and EA3 such as through a process of forming a material layer for forming a specific layer on the entire surface of the display device 10 and then etching and removing portions of the material layer formed in unwanted areas. In the display device 10, according to one or more embodiments of the invention, through the deposition and etching processes without using the mask process, the discrete patterns of the different light emitting elements ED1, ED2, and ED3 may be formed for each of the emission areas EA1, EA2, and EA3, an unnecessary component may be omitted from the display device 10, and an area of the non-display area NDA may be minimized.

A side surface shape of the bank structure BNS in a cross-sectional may be a structure formed due to a difference in etch rate between materials forming the first and second bank layers BN1 and BN2 in an etching process since the first and second bank layers BN1 and BN2 include different materials. According to an embodiment, the second bank layer BN2 may include a material having an etch rate slower than that of the first bank layer BN1, and the first bank layer BN1 may be further etched as compared to the second bank layer BN2 in the etching process, such that lower surfaces of the second bank layer BN2 which form the tips TIP of the second bank layer BN2 may be exposed at a bank opening and undercuts may be formed by the tips TIP of the second bank layer BN2 together with the first bank layer BN1.

The second bank layer BN2 may include a metal material different from the metal material of the first bank layer BN1. The metal material of the second bank layer BN2 may be any material which is removed together with the metal material of the first bank layer BN1 by dry etching, but has an etch rate much slower than that of the first bank layer BN1 or is not etched with respect to wet etching. In an embodiment, the first bank layer BN1 may include aluminium (Al) or an alloy of aluminium (Al), and the second bank layer BN2 may include titanium (Ti) or an alloy of titanium (Ti).

At the bank openings of the bank structure BNS, the tips TIP of the second bank layer BN2 may overlap the common electrodes CE1, CE2, and CE3 in a third direction DR3 perpendicular to the substrate SUB. In addition, the tips TIP of the second bank layer BN2 may overlap the light emitting layers EL1, EL2, and EL3 in the third direction DR3 perpendicular to the substrate SUB. In addition, the tips TIP of the second bank layer BN2 may overlap the pixel defining film PDL in the third direction DR3 perpendicular to the substrate SUB. The common electrodes CE1, CE2, and CE3 may be formed under the lower surfaces of the tips TIP of the second bank layer BN2. First ends and second ends of the common electrodes CE1, CE2, and CE3 which are opposite to the first ends thereof, may overlap the second bank layer BN2 in the thickness direction DR3 of the substrate. A maximum vertical distance from the substrate SUB to each of the common electrodes CE1, CE2, and CE3 may be smaller than a maximum vertical distance from the substrate SUB to the second bank layer BN2.

The thin film encapsulation layer TFEL may be disposed on the light emitting elements ED1, ED2, and ED3 and the bank structure BNS, and may cover the plurality of light emitting elements ED1, ED2, and ED3 and the bank structure BNS. The thin film encapsulation layer TFEL may include at least one inorganic film to prevent oxygen or moisture from permeating into the light emitting element layer EML. The thin film encapsulation layer TFEL may include at least one organic film to protect the light emitting element layer EML from foreign substances such as dust.

In an embodiment, the thin film encapsulation layer TFEL may include a lower inorganic encapsulation layer TFE1 (e.g., lower inorganic layer), an organic encapsulation layer TFE2 (e.g., organic layer), and an upper inorganic encapsulation layer TFE3 (e.g., upper inorganic layer) which are sequentially stacked.

Each of the lower inorganic encapsulation layer TFE1 and the upper inorganic encapsulation layer TFE3 may include one or more inorganic insulating materials. The inorganic insulating material may be any one of silicon oxide, silicon nitride, and silicon oxynitride, and may be, for example, aluminium oxide, titanium oxide, tantalum oxide, hafnium oxide, zinc oxide, silicon oxide, silicon nitride, and/or silicon oxynitride.

The organic encapsulation layer TFE2 may include a polymer-based material. The polymer-based material may include an acrylic resin, an epoxy-based resin, polyimide, polyethylene, and the like. For example, the organic encapsulation layer TFE2 may include an acrylic resin such as polymethyl methacrylate or polyacrylic acid. The organic encapsulation layer TFE2 may be formed by curing a monomer or applying a polymer.

Inorganic patterns of the lower inorganic encapsulation layer TFE1 may be disposed on the light emitting elements ED1, ED2, and ED3 and the bank structure BNS. The lower encapsulation layer TFE1 may include a first inorganic layer TL1 (e.g., first inorganic pattern), a second inorganic layer TL2 (e.g., second inorganic pattern), and a third inorganic layer TL3 (e.g., third inorganic pattern) disposed to respectively correspond to the different emission areas EA1, EA2, and EA3. The first inorganic layer TL1 as the first inorganic pattern, the second inorganic layer TL2 as the second inorganic pattern, and the third inorganic layer TL3 as the third inorganic pattern may include an inorganic insulating material and cover the light emitting elements ED1, ED2, and ED3, respectively. The first inorganic layer TL1, the second inorganic layer TL2, and the third inorganic layer TL3 may prevent the light emitting elements ED1, ED2, and ED3 from being damaged by external air.

The lower inorganic encapsulation layers TFE1 may be formed (or provided) through chemical vapor deposition (CVD), and may thus be formed along steps of layers on which they are deposited. For example, the first inorganic layer TL1, the second inorganic layer TL2, and the third inorganic layer TL3 may form thin films even under the undercuts defined by the tips TIP of the bank structure BNS. The lower inorganic encapsulation layers TL1, TL2, and TL3 may be disposed along an upper surface, the side surfaces, and a lower surface of the second bank layer BN2, the side surfaces of the first bank layer BN1, and upper surfaces of the common electrodes CE1, CE2, and CE3.

The first inorganic layer TL1 may not overlap a second bank opening and a third bank opening, and may be disposed only in a first bank opening and on the first light emitting element ED1 and along a region of the bank structure BNS which is adjacent to and extended around the first bank opening. The second inorganic layer TL2 may not overlap the first bank opening and the third bank opening, and may be disposed only in the second bank opening and on the second light emitting element ED2 and along a region of the bank structure BNS which is adjacent to and extended around the second bank opening. The third inorganic layer TL3 may not overlap the first bank opening and the second bank opening, and may be disposed only in the third bank opening and on the third light emitting element ED3 and along a region of the bank structure BNS which is adjacent to and extended around the third opening.

The first inorganic layer TL1 may be formed after the first common electrode CE1 is formed, the second inorganic layer TL2 may be formed after the second common electrode CE2 is formed, and the third inorganic layer TL3 may be formed after the third common electrode CE3 is formed. The first inorganic layer TL1, the second inorganic layer TL2, and the third inorganic layer TL3 may be disposed to be spaced apart from each other in a direction along the bank structure BNS.

The lower inorganic encapsulation layers TL1, TL2, and TL3 may include, respectively, body portions TL1_B, TL2_B, and TL3_B surrounded by the bank structure BNS and wing portions TL1_W, TL2_W, and TL3_W protruding from the body portions TL1_B, TL2 B, and TL3_B and spaced apart from the upper surface of the second bank layer BN2.

The body portions TL1_B, TL2 B, and TL3_B of the lower inorganic encapsulation layers TL1, TL2, and TL3 may cover the lower surface of the second bank layer BN2, the side surfaces of the first bank layer BN1, the capping layers CAP1, CAP2, and CAP3, and the common electrodes CE1, CE2, and CE3, and may include portions surrounded by the bank structure BNS.

The wing portions TL1_W, TL2_W, and TL3_W of the lower inorganic encapsulation layers TL1, TL2, and TL3 may include portions overlapping the second bank layer BN2 above the second bank layer BN2 and portions facing the side surfaces of the second bank layer BN2. The lower inorganic encapsulation layer TL1, TL2, and TL3 may include or define, respectively, first surfaces TL1_W_S1, TL2_W_S1, and TL3_W_S1 facing the upper surface of the second bank layer BN2 and second surfaces TL1_W_S2, TL2_W_S2, and TL3_W_S2 extended from a respective first surface facing the side surfaces of the second bank layer BN2. The first surfaces TL1_W_S1, TL2_W_S1, and TL3_W_S1 of the lower inorganic encapsulation layer may be lower surfaces defining the wing portions TL1_W, TL2_W, and TL3_W. The second surfaces TL1 _W_S2, TL2 _W_S2, and TL3_W_S2 of the lower inorganic encapsulation layer may be connecting surfaces which connect the first surfaces TL1_W_S1, TL2_W_S1, and TL3_W_S1 to the body portions TL1_B, TL2_B, and TL3_B, respectively.

Auxiliary layers AXL1, AXL2, and AXL3 may be disposed between the light emitting elements ED1, ED2, and ED3 and the lower inorganic encapsulation layers TL1, TL2, and TL3 and between the second bank layer BN2 and the lower inorganic encapsulation layers TL1, TL2, and TL3. The auxiliary layers AXL1, AXL2, and AXL3 may cover outer surfaces of various layers which are exposed to the light emission areas (e.g., within the openings formed by the bank structure BNS). That is, the auxiliary layers AXL1, AXL2, and AXL3 may be disposed on upper surfaces of the common electrodes CE1, CE2, and CE3 or the capping layers CAP1, CAP2, and CAP3, the side surfaces of the first bank layer BN1, and the lower surface of the second bank layer BN2 which is at the tips TIP. Coverage of the auxiliary layers AXL1, AXL2, and AXL3 may be better than that of the light emitting layer EL1, EL2, and EL3 and the common electrode CE1, CE2, and CE3.

The auxiliary layers AXL1, AXL2, and AXL3 may include a first auxiliary layer AXL1, a second auxiliary layer AXL2, and a third auxiliary layer AXL3 respectively disposed in the different emission areas EA1, EA2, and EA3. The first to third auxiliary layers AXL1, AXL2, and AXL3 may be spaced apart from each other.

The auxiliary layers AXL1, AXL2, and AXL3 may extend from the lower surface of the second bank layer BN2 which is at the tips TIP, to be disposed along the wing portions of the lower inorganic encapsulation layers TL1, TL2, and TL3. The auxiliary layers AXL1, AXL2, and AXL3 may extend along at least outer surfaces of the body portions TL1_B, TL2_B, and TL3_B) to be disposed within the bank openings. In embodiments, the auxiliary layers AXL1, AXL2, and AXL3 may extend out of the bank openings and along outer surfaces of the lower inorganic patterns as described below.

FIGS. 5 to 8 illustrate auxiliary layers AXL1, AXL2, and AXL3 according to embodiments, respectively. The auxiliary layers AXL1, AXL2, and AXL3 of FIGS. 5 to 8 have a difference in surface areas thereof disposed on the first surfaces TL1_W_S1, TL2_W_S1, and TL3_W_S1 and the second surfaces TL1_W_S2, TL2 _W_S2, and TL3_W_S2 of the lower inorganic encapsulation layer TL1, TL2, and TL3.

FIG. 5 is an enlarged view illustrating a first emission area EA1, specifically, area A1, of FIG. 4. Referring to FIG. 5, the auxiliary layers AXL1, AXL2, and AXL3 may cover an entirety of the first surfaces TL1_W_S1, TL2_W_S1, and TL3_W_S1 and the entirety of the second surfaces TL1_W_S2, TL2_W_S2, and TL3_W_S2 of the lower inorganic encapsulation layer TL1, TL2, and TL3, respectively. Here, outer edges (or outer side surfaces) of the auxiliary layers AXL1, AXL2, and AXL3 may coincide with, such as being coplanar with, outer edges (or outer side surfaces) of the lower inorganic patterns within the lower inorganic layer (e.g., the lower inorganic encapsulation layers TFE1).

FIG. 6 is an enlarged view illustrating area A1_1 corresponding to a first emission area EA1 and area A1 of FIG. 4. Referring to FIG. 6, the auxiliary layers AXL1, AXL2, and AXL3, represented by auxiliary layer AXL1_1 may cover inner portions of the first surfaces TL1_W_S1, TL2_W_S1, and TL3_W_S1 and an entirety of the second surfaces TL1_W_S2, TL2_W_S2, and TL3_W_S2 of the lower inorganic encapsulation layer TL1, TL2, and TL3, respectively. Here, the outer edges of the auxiliary layers AXL1, AXL2, and AXL3 may not coincide with the outer edges of the lower inorganic patterns within the lower inorganic layer (e.g., the lower inorganic encapsulation layers TFE1). Instead, the distal ends of the auxiliary layers AXL1, AXL2, and AXL3 which are furthest from the light emission areas, respectively, may be spaced apart from (or recessed from) the outer edges of the lower inorganic patterns. A lower surface of the lower inorganic patterns (e.g., portions of the first surfaces TL1_W_S1, TL2_W_S1, and TL3_W_S1) may be exposed outside of the auxiliary patterns of the auxiliary layer (e.g., the auxiliary layers AXL1, AXL2, and AXL3) as an exposed portion of the lower inorganic patterns.

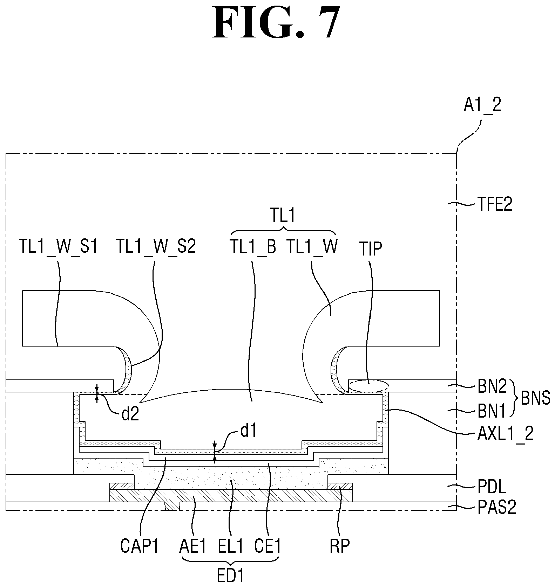

FIG. 7 is an enlarged view illustrating area A1_2 corresponding to a first emission area EA1 and area A1 of FIG. 4. Referring to FIG. 7, the auxiliary layers AXL1, AXL2, and AXL3 represented by auxiliary layer AXL1_2 may not cover the first surfaces TL1_W_S1, TL2_W_S1, and TL3_W_S1 of the lower inorganic encapsulation layer TL1, TL2, and TL3, respectively, and may cover an entirety or portions of the second surfaces TL1_W_S2, TL2_W_S2, and TL3_W_S2 of the lower inorganic encapsulation layer TL1, TL2, and TL3, respectively. Here, an entirety of the first surfaces TL1_W_S1, TL2_W_S1, and TL3_W_S1 are exposed outside of the auxiliary patterns of the auxiliary layer (e.g., the auxiliary layers AXL1, AXL2, and AXL3) to define an exposed portion of the lower inorganic patterns.

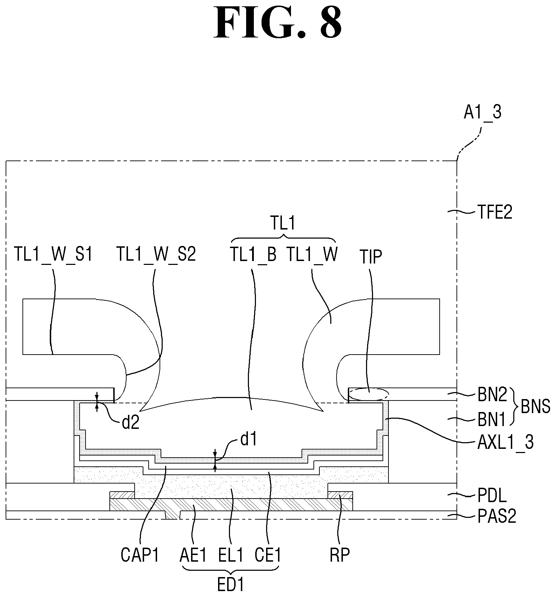

FIG. 8 is an enlarged view illustrating area A1_3 corresponding to a first emission area EA1 and area A1 of FIG. 4. Referring to FIG. 8, the auxiliary layers AXL1, AXL2, and AXL3 represented by auxiliary layer AXL1_3 may not be disposed on the first surfaces TL1_W_S1, TL2_W_S1, and TL3_W_S1 and the second surfaces TL1_W_S2, TL2_W_S2, and TL3_W_S2 of the lower inorganic encapsulation layer TL1, TL2, and TL3, respectively. The auxiliary layers AXL1, AXL2, and AXL3 may be disposed only on the lower surface of the second bank layer BN2 which is at the tips TIP and along the inorganic bodies (e.g., the body portions TL1_B, TL2_B, and TL3_B). In an embodiment, the auxiliary layer may be optionally disposed on the first surfaces TL1_W_S1, TL2_W_S1, and TL3_W_S1 and the second surfaces TL1_W_S2, TL2 _W_S2, and TL3_W_S2 of the lower inorganic encapsulation layer TL1, TL2, and TL3, respectively.

Contact areas of the auxiliary layers AXL1, AXL2, and AXL3 with respect to the lower inorganic patterns may be adjusted by controlling wet etching of the auxiliary layers AXL1, AXL2, and AXL3.

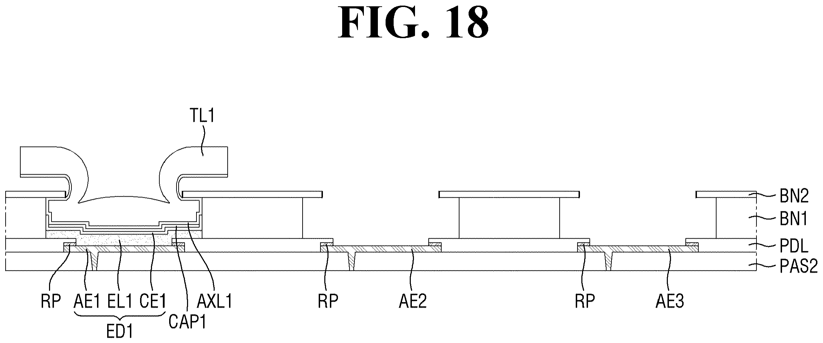

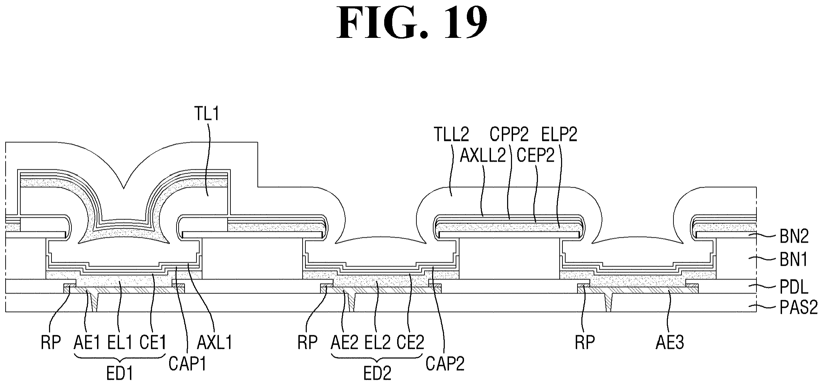

In an embodiment of providing the display panel 100, after the first light emitting layer EL1, the first common electrode CE1, the first auxiliary layer AXL1, the first capping layer CAP1 and the first inorganic layer TL1 are formed in the first emission area EA1 to define a first stacked structure on a substrate SUB (FIG. 18, for example), the second light emitting layer EL2, the second common electrode CE2, the second auxiliary layer AXL2, and the second inorganic layer TL2 may be formed in the second emission area EA2. In this case, respective material layers are deposited across an entirety of the substrate SUB having the first stacked structure thereon, such as to provide a second light emitting pattern layer ELP2, a second electrode pattern layer CEP2, a second capping pattern layer CPP2, a second auxiliary material layer AXLL2, and a second inorganic material layer TLL2 may be formed on the first inorganic layer TL1 covering the first emission area EA1 and the periphery of the first emission area EA1 (FIG. 19, for example).

The second light emitting pattern layer ELP2 may be made of the same material as the second light emitting layer EL2, the second electrode pattern layer CEP2 may be made of the same material as the second common electrode CE2, the second capping pattern layer CPP2 may be made of the same material as the second capping layer CAP2, and the second auxiliary material layer AXLL2 may be made of the same material as the second auxiliary layer AXL2. That is, the second light emitting pattern layer ELP2 and the second light emitting layer EL2, the second electrode pattern layer CEP2 and the second common electrode CE2, the second capping pattern layer CPP2 and the second capping layer CAP2, and the second auxiliary material layer AXLL2 and the second auxiliary layer AXL2 may be in a same layer as each other, respectively. As being in a same layer, elements may be formed in a same process and/or include a same material as each other, elements may be respective portions of a same material layer, elements may be on a same layer by forming an interface with a same underlying or overlying layer, etc., without being limited thereto.

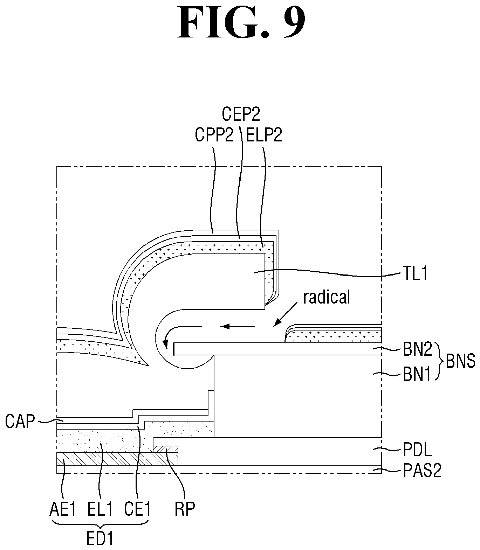

As illustrated in FIG. 9, due to an undercut structure under the wing portion TL1_W of the first inorganic layer TL1, a gap is defined between the wing portion TL1_W of the first inorganic layer TL1 and an area of the second bank layer BN2 which is closest to the first emission area EA1. An inlet of the gap is defined at an outer edge (e.g., a boundary) of the first inorganic layer TL1.

When material portions of the auxiliary layers AXL1, AXL2, and AXL3 are not disposed between the lower surface of the second bank layer BN2 and the lower inorganic encapsulation layers TL1, TL2, and TL3, respectively, the second light emitting pattern layers ELP2, the second electrode pattern layers CEP2 and the second capping pattern layers CPP2 are disconnected from each other and have a gap formed therebetween at the boundary of the first inorganic layer TL1, as illustrated in FIG. 9, due to an undercut structure under the wing portion TL1_W of the first inorganic layer TL1. After the second inorganic material layer TLL2 is formed above the underlying stacked structure, only a portion of the second inorganic material layer TLL2 disposed in the second emission area EA2 and around the second emission area EA2 remains as the second inorganic layer TL2, and other portions the second inorganic material layer TLL2 disposed in the remaining areas is removed through an etching process.

In the etching process, a radical of an etchant for removing the other portions of the second inorganic material layer TLL2 may penetrate into the gap and to under the tip TIP. Referring to FIG. 9, for example, the radical penetrating into the gap (see arrows in FIG. 9) passes between the wing portion TL1_W of the first inorganic layer TL1 and the second bank layer BN2 and then penetrates through or past the lower surface of the second bank layer BN2 to remove an edge portion of the first inorganic layer TL1 which defines the first bank opening and weaken adhesion or encapsulation between the bank structure BNS and the first inorganic layer TL1 at the first bank opening. This may lead to moisture permeation or cause damage to the first light emitting element ED1, resulting in a dark spot in the display device 10.

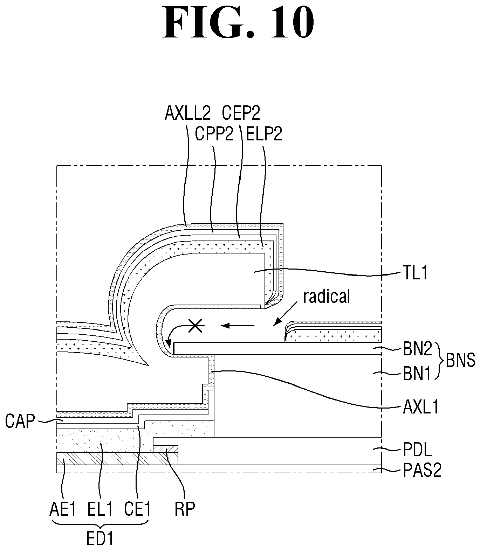

In contrast, when the auxiliary layers AXL1, AXL2, and AXL3 are disposed between the lower surface of the second bank layer BN2 and the lower inorganic encapsulation layers TL1, TL2, and TL3, respectively, the permeation of the radical of the etchant between the lower surface of the second bank layer BN2 and the first inorganic layer TL1 may be prevented, as illustrated in FIG. 10. Here, the auxiliary patterns effectively cover the inner side surfaces of the first bank layer BN1 together with the lower surface of the tips TIP, to prevent contact of the etchant with the bank structure BNS and the lower inorganic patterns. The first inorganic layer TL1 may not be exposed to the etchant, and the damage to the first light emitting element ED1 may be prevented. In addition, since a pattern portion of the auxiliary layers remains in the final stacked structure, at least within the bank opening and along surfaces exposed thereto, moisture penetration from external air may be prevented, and a difference in luminance between the light emitting elements ED1, ED2, and ED3 may be reduced.

In an embodiment, the auxiliary layers AXL1, AXL2, and AXL3 may be in contact with the lower surface of the second bank layer BN2 and the side surfaces of the first bank layer BN1.

The auxiliary layers AXL1, AXL2, and AXL3 may be formed through a sputtering process. Thicknesses of the auxiliary layers AXL1, AXL2, and AXL3 may be different from each other depending on directions in which materials of the auxiliary layers AXL1, AXL2, and AXL3 are provided. A thickness of a material layer may be defined at various locations of an underlying surface along which the material layer extends, in a direction normal to such underlying surface.

A first thickness d1 of the auxiliary layers AXL1, AXL2, and AXL3 relative to the upper surfaces of the common electrode CE1, CE2, and CE3 and a second thickness d2 of the auxiliary layers AXL1, AXL2, and AXL3 relative to the lower surface of the second bank layer BN2 may be different from each other. A third thickness d3 of the auxiliary layers AXL1, AXL2, and AXL3 relative to the first surfaces TL1_W_S1, TL2_W_S1, and TL3_W_S1 of the lower inorganic encapsulation layers TL1, TL2, and TL3 and the second thickness d2 of the auxiliary layers AXL1, AXL2, and AXL3 relative to the lower surface of the second bank layer BN2 may be different from each other. The first thickness d1 of the auxiliary layers AXL1, AXL2, and AXL3 relative to the upper surfaces of the common electrode CE1, CE2, and CE3 and the third thickness d3 of the auxiliary layers AXL1, AXL2, and AXL3 relative to the first surfaces TL1_W_S1, TL2_W_S1, and TL3_W_S1 of the lower inorganic encapsulation layers TL1, TL2, and TL3 may be the same as or similar to each other.

The second thickness d2 of the auxiliary layers AXL1, AXL2, and AXL3 relative to the lower surface of the second bank layer BN2 may be very small. The auxiliary layers AXL1, AXL2, and AXL3 on the lower surface of the second bank layer BN2 may have a form in which material particles constituting the auxiliary layers AXL1, AXL2, and AXL3 may remain on the lower surface of the second bank layer BN2, and a density of these material particles may be very low. On the other hand, the first thickness d1 or the third thickness d3 of the auxiliary layers AXL1, AXL2, and AXL3 relative to the upper surfaces of the common electrodes CE1, CE2, and CE3 or the first surfaces TL1_W_S1, TL2_W_S1, and TL3_W_S1 of the lower inorganic encapsulation layers TL1, TL2, and TL3 may be relatively greater than the second thickness d2 of the first auxiliary layer relative to the lower surface of the second bank layer.

The auxiliary layers AXL1, AXL2, and AXL3 may include transparent conductive oxide (TCO). A material of the transparent conductive oxide (TCO) may be one or more of indium tin oxide (ITO), indium zinc oxide (IZO), indium tin zinc oxide (ITZO), zinc indium tin oxide (ZITO), indium gallium zinc oxide (IGZO), indium tin oxide (IZO), and zinc tin oxide (ZTO), and may be mixed with some metals or silicon. The transparent conductive oxide (TCO) included in the auxiliary layers AXL1, AXL2, and AXL3 may be amorphous.

Arrangements of the first to third auxiliary layers AXL1, AXL2, and AXL3 along the first surfaces TL1_W_S1, TL2_W_S1, and TL3_W_S1 and along the second surfaces TL1_W_S2, TL2_W_S2, and TL3_W_S2 of the lower inorganic encapsulation layer TL1, TL2, and TL3 may be the same as or different from each other. The first to third auxiliary layers AXL1, AXL2, and AXL3 may all have a shape as illustrated in FIG. 6 or the first auxiliary layer AXL1 may be disposed as illustrated in FIG. 6, the second auxiliary layer AXL2 may be disposed as illustrated in FIG. 7, and the third auxiliary layer AXL3 may be disposed as illustrated in FIG. 8.

The organic encapsulation layer TFE2 is disposed on the second bank layer BN2 and the lower inorganic encapsulation layers TL1, TL2, and TL3. Portions of the organic encapsulation layer TFE2 may be disposed between the upper surface of the second bank layer BN2 and the wing portions TL1_W, TL2_W, and TL3_W of the lower inorganic encapsulation layers TL1, TL2, and TL3, within the gaps. When the auxiliary layers AXL1, AXL2, and AXL3 are disposed on the first surfaces TL1_W_S1, TL2_W_S1, and TL3_W_S1 of the lower inorganic encapsulation layer TL1, TL2, and TL3, respectively, portions of the organic encapsulation layer TFE2 may be disposed between the auxiliary layers AXL1, AXL2, and AXL3 and the upper surface of the second bank layer BN2, at the gaps.

The organic encapsulation layer TFE2 may be in contact with the second bank layer BN2. The second bank layer BN2 in areas overlapping the light emitting layers EL1, EL2, and EL3 in the thickness direction DR3 of the substrate SUB, in areas adjacent to the light emission areas, may be in contact with the organic encapsulation layer TFE2. The second bank layer BN2 in areas overlapping the wings TL1_W, TL2_W, and TL3_W of the lower inorganic encapsulation layers TL1, TL2, and TL3 in the thickness direction DR3 of the substrate SUB, in areas adjacent to the light emission areas, may be in contact with the organic encapsulation layer TFE2.

Portions of the organic encapsulation layer TFE2 may be disposed between the second surfaces TL1_W_S2, TL2 _W_S2, and TL3_W_S2 of the lower inorganic encapsulation layers TL1, TL2, and TL3, and the side surfaces of the second bank layer BN2, respectively. The side surfaces of the second bank layer BN2 may be in contact with the organic encapsulation layer TFE2, the auxiliary layers AXL1, AXL2, and AXL3, and/or the lower inorganic encapsulation layer TL1, TL2, and TL3.

The upper inorganic encapsulation layer TFE3 may be disposed on the organic encapsulation layer TFE2. The upper inorganic encapsulation layer TFE3 may include aluminium oxide, titanium oxide, tantalum oxide, hafnium oxide, zinc oxide, silicon oxide, silicon nitride, and/or silicon oxynitride.

The light blocking layer BM including light blocking patterns and openings defined therebetween, may be disposed on the thin film encapsulation layer TFEL. The light blocking layer BM may include (or define) a plurality of holes OPT1, OPT2, and OPT3 disposed to overlap the emission areas EA1, EA2, and EA3. For example, a first hole OPT1 may be disposed to overlap the first emission area EA1. A second hole OPT2 may be disposed to overlap the second emission area EA2, and a third hole OPT3 may be disposed to overlap the third emission area EA3. An area or a size of each of the holes OPT1, OPT2, and OPT3 may be greater than the area or the size of each of the emission areas EA1, EA2, and EA3. The holes OPT1, OPT2, and OPT3 of the light blocking layer BM are formed to be greater than the emission areas EA1, EA2, and EA3. Accordingly, the light emitted from the emission areas EA1, EA2, and EA3 may be viewed from outside the display device 10, such as by a user, not only from a front surface furthest along the third direction DR3 but also from side surfaces of the display device 10.

The solid portions of the light blocking layer BM may include a light absorbing material. For example, the light blocking layer BM may include an inorganic black pigment or an organic black pigment. The inorganic black pigment may be carbon black, and the organic black pigment may include at least one of lactam black, perylene black, and aniline black, but the present disclosure is not limited thereto. The light blocking layer BM may prevent color mixing due to permeation of visible light between the first to third emission areas EA1, EA2, and EA3 to improve a color gamut of the display device 10.

The display device 10 may include a plurality of color filters CF1, CF2, and CF3 disposed on the emission areas EA1, EA2, and EA3. The plurality of color filters CF1, CF2, and CF3 may be disposed to correspond to the emission areas EA1, EA2, and EA3, respectively. For example, the color filters CF1, CF2, and CF3 may be disposed on the light blocking layer BM including the plurality of holes OPT1, OPT2, and OPT3 disposed to correspond to the emission areas EA1, EA2, and EA3. The holes of the light blocking layer BM may be formed to overlap the emission areas EA1, EA2, and EA3 or the bank openings of the bank structures BNS, and may form light emitting areas through which the light emitted from the emission areas EA1, EA2, and EA3 is emitted. Each of the color filters CF1, CF2, and CF3 may have a greater area than each of the holes of the light blocking layer BM, and may completely cover the light emitting area formed at each of the holes.

The color filters CF1, CF2, and CF3 may include a first color filter CF1, a second color filter CF2, and a third color filter CF3 disposed to each correspond to the different emission areas EA1, EA2, and EA3. The color filters CF1, CF2, and CF3 may include colorants such as dyes or pigments absorbing light of wavelength bands other than light of a specific wavelength band, and may be disposed to correspond to the colors of the light emitting from the emission areas EA1, EA2, and EA3. For example, the first color filter CF1 may be a red color filter disposed to overlap the first emission area EA1 and transmitting only the first light, which is the red light, therethrough. The second color filter CF2 may be a green color filter disposed to overlap the second emission area EA2 and transmitting only the second light, which is the green light, therethrough, and the third color filter CF3 may be a blue color filter disposed to overlap the third emission area EA3 and transmitting only the third light, which is the blue light, therethrough.

The plurality of color filters CF1, CF2, and CF3 may be spaced apart from other adjacent color filters CF1, CF2, and CF3, along the light blocking layer BM. The color filters CF1, CF2, and CF3 may have greater areas than the holes OPT1, OPT2, and OPT3 of the light blocking layer BM while covering the holes OPT1, OPT2, and OPT3 of the light blocking layer BM, respectively, but may have areas small enough to be spaced apart from other color filters CF1, CF2, and CF3 along the light blocking layer BM. However, the present disclosure is not limited thereto. The plurality of color filters CF1, CF2, and CF3 may be disposed to partially overlap other adjacent color filters CF1, CF2, and CF3. Different color filters CF1, CF2, and CF3 may overlap each other on a solid portion of the light blocking layer BM to be described later, which is an area which does not overlap the emission areas EA1, EA2, and EA3. In the display device 10, the color filters CF1, CF2, and CF3 are disposed to overlap each other, and accordingly, an intensity of reflected light by external light may be reduced. Furthermore, a color feeling of the reflected light by the external light may be controlled by adjusting an arrangement, shapes, areas, and the like, of the color filters CF1, CF2, and CF3 in plan view.

The overcoat layer OC may be disposed on the color filters CF1, CF2, and CF3 to planarize upper ends of the color filters CF1, CF2, and CF3. The overcoat layer OC may be a colorless light transmitting layer which does not have a color of a visible light band. For example, the overcoat layer OC may include a colorless light transmitting organic material such as an acrylic resin.

Hereinafter, processes for fabrication or providing of the display device 10 according to an embodiment will be described with reference to other drawings.

FIGS. 11 to 23 are detailed cross-sectional views sequentially illustrating processes for fabrication of (or providing of) the display device 10 according to an embodiment.

In FIGS. 11 to 23, processes of forming the bank structure BNS and the light emitting elements ED of the light emitting element layer EML, and the thin film encapsulation layer TFEL on the light emitting element layer EML, of the display device 10 are schematically illustrated. Hereinafter, a description of processes of forming respective layers among the processes for fabrication of the display device 10 will be omitted, and the order of forming the respective layers will be described.

Referring to FIG. 11, a plurality of pixel electrodes AE1, AE2, and AE3 spaced apart from each other, sacrificial layers SFL as sacrificial patterns of a sacrificial layer, a pixel defining material layer PDLL as a preliminary pixel defining layer, and a plurality of bank material layers BNL1 and BNL2 as preliminary bank layers of a bank structure BNS are formed or provided on the second passivation layer PAS2 as a preliminary stacked structure.

Although not illustrated in FIG. 11, the thin film transistor layer TFTL may be disposed on the substrate SUB having the preliminary stacked structure thereon, and a structure of the thin film transistor TFTL is the same as that described above with reference to FIG. 4. A detailed description thereof will be omitted.

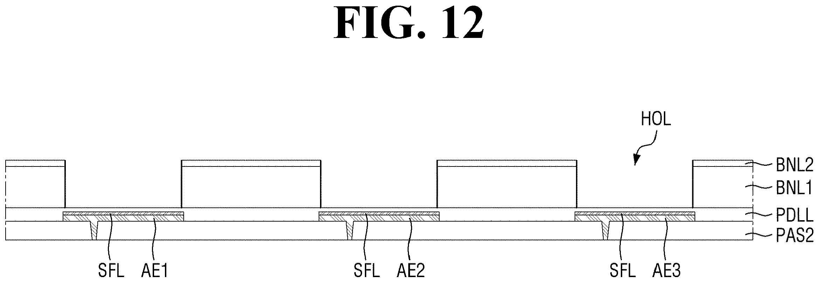

Subsequently, referring to FIG. 12, a photoresist (not illustrated) is formed on a second bank material layer BNL2, and a first etching process (1^{st} etching) of etching portions of first and second bank material layers BNL1 and BNL2 using the photoresist as a mask is performed. Preliminary holes HOL may be formed through the first etching process. The photoresist patterns may be disposed so as to be spaced apart from each other along the second bank material layer BNL2, and may be disposed to expose areas of the second bank material layer BNL2 which respectively overlap the plurality of pixel electrodes AE1, AE2, and AE3.

In an embodiment, anisotropic dry etching may be performed as the first etching process (1^{st} etching). The preliminary holes HOL may be formed in the areas overlapping the plurality of pixel electrodes AE1, AE2, and AE3, and may correspond to the bank openings of the bank structure BNS. Exposed portions of the preliminary pixel defining layer may be exposed at the preliminary holes HOL to outside the preliminary bank layers.

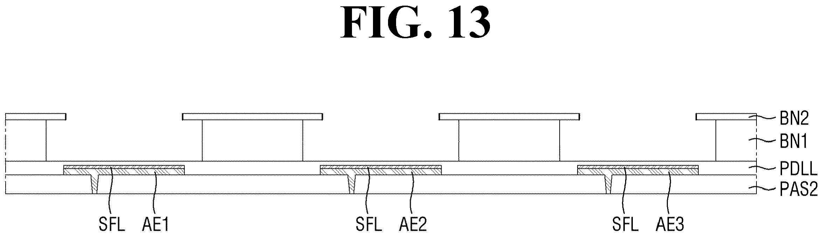

Next, referring to FIG. 13, undercut structures of the first bank layer BN1 may be formed through a second etching process (2^{nd} etching). The first bank material layer BNL1 may have a faster etch rate than the second bank material layer BNL2, owing to the respective materials thereof. Here, side surfaces of the first bank layer BN1 may be recessed from side surfaces of the second bank layer BN2, to form the undercut structures at opposing sides of light emission areas. The second bank layer BN2 protrudes further than the side surfaces of the first bank layer BN1 in a direction toward the preliminary holes HOL to form tips TIP having the side surfaces of the second bank layer BN2, and undercuts may be formed by the tips TIP relative to the side surfaces of the first bank layer BN1.

In an embodiment, the second etching process may be isotropic wet etching. In the second etching process, an alkali-based etchant may be used. The bank structure BNS including the first and second bank layers BN1 and BN2 may be obtained through the second etching process.

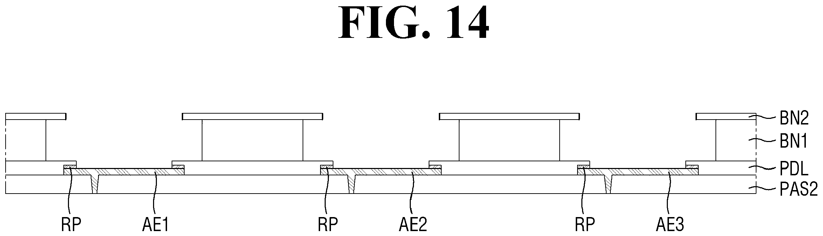

Subsequently, as illustrated in FIG. 14, the exposed portions of the pixel defining material layer PDLL may be removed at the preliminary holes HOL, and portions of the sacrificial layers SFL may also be removed at the preliminary holes HOL, through a third etching process (3^{rd} etching). The third etching process may include a dry etching step of removing the exposed portions of the pixel defining material layer PDLL and a wet etching step of removing the portions of the sacrificial layers SFL. Here, patterns of the pixel defining film PDL and residual patterns RP thereunder may be formed to expose areas of the pixel electrodes AE1, AE2, and AE3 to outside the pixel defining film PDL. The pixel defining layer may define pixel openings therein corresponding to the light emission areas (e.g., the emission areas EA1, EA2 and EA3). Within the pixel openings, the residual patterns RP may be within the pixel openings, to occupy a volume thereof between the pixel electrodes AE1, AE2, and AE3 and a protruding portion of the pixel defining film PDL.

The sacrificial layers SFL may protect the pixel electrodes AE1, AE2, and AE3 from plasma in the dry etching step. Portions of the sacrificial layers SFL which are exposed by the preliminary holes HOL and portions of the sacrificial layers SFL which are respectively between the first bank material layer BNL1 and the pixel electrodes AE1, AE2, and AE3 may be removed. However, the sacrificial layers SFL may not be completely removed, and may remain as partial residual patterns RP between the protruded portions of the pixel defining film PDL, and the pixel electrodes AE1, AE2, and AE3, respectively. The pixel electrodes AE1, AE2, and AE3 may be exposed to outside the pixel defining film PDL and the bank structure BNS through the third etching process.

Through the processes of FIGS. 11 to 14, the plurality of pixel electrodes AE1, AE2, and AE3 spaced apart from each other, the pixel defining film PDL exposing the exposed pixel electrodes, the first bank layer BN1 disposed on the pixel defining film PDL, and the second bank layer BN2 protruding further than the inner side surfaces of the first bank layer BN1 may be prepared on the substrate SUB to define a base stacked structure.

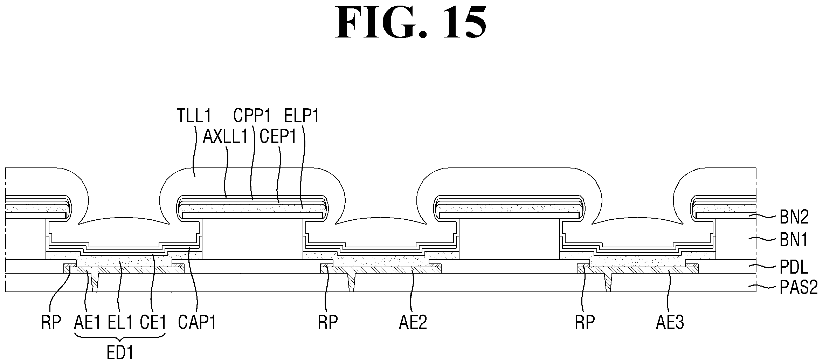

Subsequently, as illustrated in FIG. 15, on the base stacked structure, the first light emitting element ED1 is formed by sequentially stacking the first light emitting layer EL1 and the first common electrode CE1 on the first pixel electrode AE1, and the first capping layer CAP1 is formed on the first common electrode CE1. In this case, materials layers of the first light emitting layer EL1, the first common electrode CE1, and the first capping layer CAP1 are formed on the entire surface of the substrate SUB. Thus, a first light emitting pattern layer ELP1, a first electrode pattern layer CEP1, and a first capping pattern layer CPP1 may be formed on the second bank layer BN2, together with the first light emitting layer EL1 and the first common electrode CE1 on the first pixel electrode AE1, and the first capping layer CAP1.

Among respective material layers, the first light emitting layer EL1 and the first light emitting pattern layer ELP1 may be separated from each other by the tips TIP of the second bank layer BN2, the first common electrode CE1 and the first electrode pattern layer CEP1 may be separated from each other by the tips TIP of the second bank layer BN2, and the first capping layer CAP 1 and the first capping pattern layer CPP1 may be separated from each other by the tips TIP of the second bank layer BN2. The first light emitting layer EL1 is formed on the first pixel electrode AE1, and at the same time, the first light emitting pattern layer ELP1 may be formed on the second bank layer BN2. The first common electrode CE1 is formed on the first light emitting layer EL1, and at the same time, the first electrode pattern layer CEP1 may be formed on the first light emitting pattern layer ELP1. The first capping layer CAP1 is formed in the bank opening, and at the same time, the first capping pattern layer CPP1 may be formed on the first electrode pattern layer CEP1.

The first light emitting layer EL1 and the first common electrode CE1 may be formed through thermal deposition processes. Materials may not be smoothly deposited within the openings due to the tips TIP of the second bank layer BN2. However, materials of the first light emitting layer EL1 and the first common electrode CE1 are deposited in a direction inclined with an upper surface of the substrate SUB rather than in a direction perpendicular to the upper surface of the substrate SUB, and may thus be deposited even in areas under the tips TIP of the second bank layer BN2.

The deposition process of forming the common electrodes CE1, CE2, and CE3 may be performed in an inclined direction relatively closer to a horizontal direction than the deposition process of forming the light emitting layers EL1, EL2, and EL3. Accordingly, the common electrodes CE1, CE2, and CE3 may be in contact with the side surfaces of the first bank layer BN1 which are exposed to the bank openings in a greater area than the light emitting layers EL1, EL2, and EL3. Alternatively, the common electrodes CE1, CE2, and CE3 may be deposited up to a higher position on the side surfaces of the first bank layer BN1 which are exposed to the bank openings than the light emitting layers EL1, EL2, and EL3. Different common electrodes CE1, CE2, and CE3 may be in contact with the first bank layer BN1 having high conductivity to be electrically connected to each other.

Subsequently, a first auxiliary material layer AXLL1 covering the first light emitting element ED1 and the first capping layer CAP1 is formed. The first auxiliary material layer AXLL1 may be formed to completely cover outer surfaces of the first light emitting element ED1, the inner side surfaces of the first and second bank layers BN1 and BN2, the first capping layer CAP1, the first light emitting pattern layer ELP1, the first electrode pattern layer CEP1, and the first capping pattern layer CPP1 without any disconnected portions (e.g., continuously). Specifically, the first auxiliary material layer AXLL1 is formed on an upper surface of the first common electrode CE1, an upper surface of the first capping layer CAP1, the side surfaces of the first bank layer BN1 which are exposed at the bank opening, a lower surface and an upper surface of the second bank layer BN2, and upper surfaces of the first electrode pattern layer CEP1 and the first capping pattern layer CPP1.

In an embodiment, the first auxiliary material layer AXLL1 may be formed through a sputtering process. When the first auxiliary material layer AXLL1 is formed through the sputtering process, step coverage of the first auxiliary material layer AXLL1 is better than that of materials for forming the light emitting layer EL1, EL2, and EL3 and the common electrode CE1, CE2, and CE3, such that a film of the first auxiliary material layer AXLL1 may be formed even on the lower surface of the second bank layer BN2.

Subsequently, a first inorganic material layer TLL1 covering the first auxiliary material layer AXLL1 is formed. In an embodiment, the first inorganic material layer TLL1 may be formed through chemical vapor deposition (CVD). The first inorganic material layer TLL1 may be formed along a step of the first auxiliary material layer AXLL1, that is, to follow a profile of the first auxiliary material layer AXLL1 even within the bank openings and out of the bank openings.

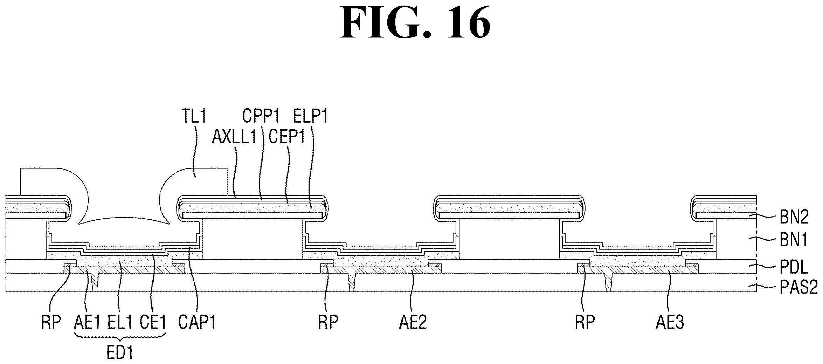

Next, referring to FIG. 16, a fourth etching process (4^{th} etching) of exposing the first auxiliary material layer AXLL1 by removing a portion of the first inorganic material layer TLL1 is performed. A photoresist (not illustrated), which is a mask, is formed in an area overlapping the first emission area EA1 and an edge area which surrounds the first emission area EA1, and the first inorganic material layer TLL1 which is not covered by the mask is removed. Through the fourth etching process, the first inorganic layer TL1 remains as a first inorganic pattern in the area overlapping the first emission area EA1 and the edge area which surrounds the first emission area EA1, while a remainder of the first inorganic material layer TLL1 is removed. In an embodiment, the fourth etching process may be anisotropic dry etching.

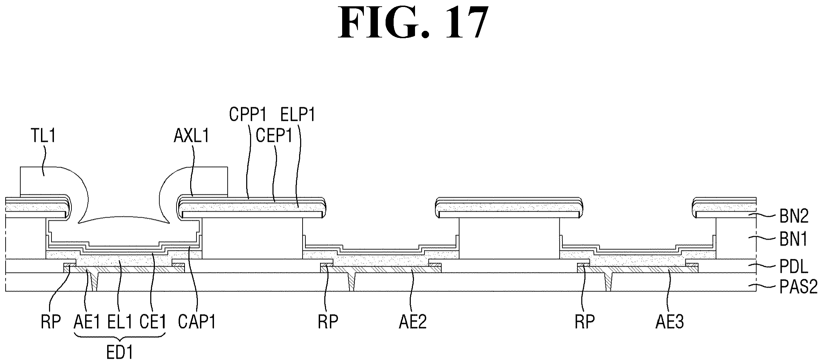

Subsequently, referring to FIG. 17, a fifth etching process (5^{th} etching) of removing an exposed portion of the first auxiliary material layer AXLL1 is performed. Through the fifth etching process, the first auxiliary layer AXL1 disposed between the first inorganic layer TL1 and the first capping pattern layer CPP1 and between the first inorganic layer TL1 and the first light emitting element ED1 is formed as a first auxiliary pattern of the first auxiliary material layer AXLL1. In an embodiment, the fifth etching process may be wet etching. By controlling a wet etching process, an area of the first auxiliary layer AXL1 between the first inorganic layer TL1 and the first capping pattern layer CPP1, as illustrated in FIGS. 5 to 8, may be adjusted.

Here, a stacked pattern layer including the first light emitting pattern layer ELP1, the first electrode pattern layer CEP1, and the first capping pattern layer CPP1 is disposed at each of the banks of the bank structure BNS and a stacked pattern layer including the first light emitting layer EL1, the first common electrode CE1 and the first capping layer CAP1 at light emission areas other than the first emission area EA1, are exposed to outside the first inorganic pattern and the first auxiliary pattern.

Next, referring to FIG. 18, a sixth etching process (6^{th} etching) of exposing the second bank layer BN2 by removing the first capping pattern layer CPP1, the first electrode pattern layer CEP1, and the first light emitting pattern layer ELP1 is performed. In an embodiment, the sixth etching process may include an isotropic wet etching step. Not only the first capping pattern layer CPP1, the first electrode pattern layer CEP1, and the first light emitting pattern layer ELP1 disposed on the second bank layer BN2, but also the first light emitting pattern layer ELP1, the first electrode pattern layer CEP1, and the first capping pattern layer CPP1 in the second and third emission areas EA2 and EA3 which are not covered with first inorganic material layer TLL1 may be removed. That is, the stacked pattern layers discussed above which are exposed to outside the first inorganic pattern and the first auxiliary pattern are removed. Accordingly, the first light emitting pattern layer ELP1, the first electrode pattern layer CEP1, and the first capping pattern layer CPP1 disposed between the wing portion TL1_W of the first inorganic layer TL1 and the second bank layer BN2 may also be removed, and undercut structures of the first inorganic layer TL1 may be formed. Also, the first inorganic layer TL1 as a first inorganic pattern and the first auxiliary layer AXL1 as a first auxiliary pattern overlapping the first emission area EA1 may be obtained.

Referring to FIG. 18, gap is defined under the wing portion TL1_W at an overlapped region of the second bank layer BN2, and extends to under the tip TIP of the second bank layer BN2. However, the first auxiliary layer AXL1 extends from under the tip TIP and along an outer surface of the wing portion, to cover the gap opening and block exposure of the first inorganic layer TL1, the second bank layer BN2 and the first bank layer BN1.

Subsequently, as illustrated in FIG. 19, the second light emitting layer EL2, the second common electrode CE2, and the second capping layer CAP2 are deposited on the second pixel electrode AE2 to form the second light emitting element ED2. Material layers for forming the second light emitting layer EL2, the second common electrode CE2, and the second capping layer CAP2 are provided on an entirety of the substrate SUB having the first inorganic patterns and the first auxiliary patterns thereon. Here, the material layers are respectively disconnected at the various wings of the first inorganic patterns, to provide patterns thereof including the second light emitting layer EL2, the second common electrode CE2, and the second capping layer CAP2 at the light emission areas together with the second light emitting pattern layers ELP2, the second electrode pattern layers CEP2, and the second capping pattern layers CPP2 on the banks of the bank structure BNS.

The second light emitting layer EL2, the second common electrode CE2, and the second capping layer CAP2 which are provided overlapping the first inorganic layer TL1 are disconnected from the second light emitting pattern layers ELP2, the second electrode pattern layers CEP2, the second capping pattern layers CPP2 which are adjacent to the first inorganic layer TL1, as illustrated in FIG. 19. At the boundary of the first inorganic layer TL1, the stack of the second light emitting pattern layers ELP2, the second electrode pattern layers CEP2 and the second capping pattern layers CPP2 are disposed adjacent to the inlet of the gap under the wing portion TL1_W. This stack may be adjacent to a distal end of the previously-formed first auxiliary layer AXL1, to essential block or minimize the inlet of the gap. Referring to FIG. 19, the gap may be bounded by the first auxiliary layer AXL1, the second bank layer BN2 and the inner side surfaces of the stack.

Thereafter, on all of the disconnected patterns, the second auxiliary material layer AXLL2 and the second inorganic material layer TLL2 covering the second light emitting element ED2 and the second capping layer CAP2 are formed. In this process, materials are deposited on the entire surface of the substrate SUB having the first inorganic patterns, the first auxiliary patterns and all of the disconnected patterns as illustrated in FIG. 19. The second auxiliary material layer AXLL2 extends along the stack of the second light emitting pattern layers ELP2, the second electrode pattern layers CEP2 and the second capping pattern layers CPP2 disposed at the inlet of the gap. While FIG. 19 show the second auxiliary material layer AXLL2 as continuous or integral with the previously-formed first auxiliary layer AXL1, it will be understood that a virtual boundary may be defined therebetween.

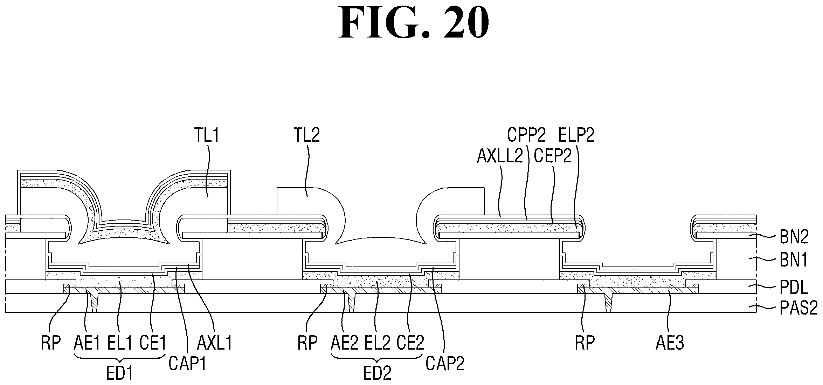

Next, as illustrated in FIG. 20, the second inorganic layer TL2 overlapping the second emission area EA2 and an edge surrounding the second emission area EA2 may be formed by removing a portion of the second inorganic material layer TLL2 except for locations overlapping the second emission area EA2 and an edge surrounding the second emission area EA2. This process may be performed similarly to the dry etching step of removing the first inorganic material layer TLL1 of FIG. 16. Here, the second auxiliary material layers AXLL2 may remain as a continuous layer across an entirety of the substrate SUB, even extending under the second inorganic layer TL2 as a second inorganic pattern.

Referring back to FIG. 9 together with FIGS. 18 and 19, without the previously-formed pattern of the first auxiliary layer AXL1 to essentially block or minimize the inlet of the gap, the radical of the etchant may permeate into the gap. However, referring to FIG. 10 together with FIGS. 19 to 20, since at least the previously-formed pattern of the first auxiliary layer AXL1 is disposed on the lower surface of the second bank layer BN2 and extended along the gap, the radical of the etchant does not damage the first inorganic layer TL1.

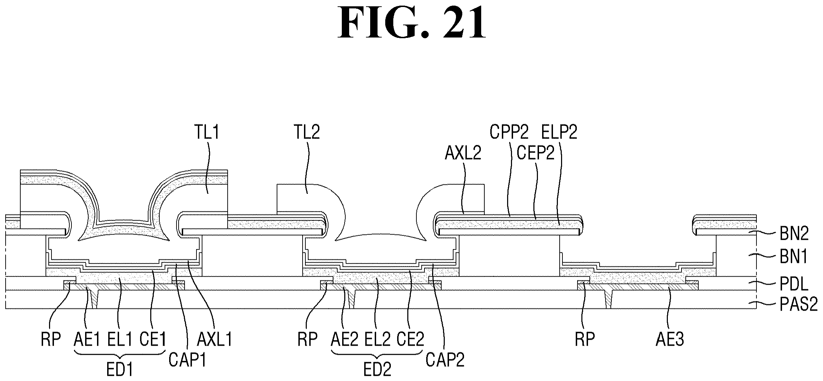

Subsequently, as illustrated in FIG. 21, a portion of the second auxiliary material layer AXLL2 may be removed. Here, the second auxiliary layer AXL2 overlapping the second emission area EA2 and an edge surrounding the second emission area EA2 may be formed by removing a portion of the second auxiliary material layers AXLL2 except for locations overlapping the second emission area EA2 and an edge surrounding the second emission area EA2. This process may proceed similarly to FIG. 17.

Here, a stacked pattern layer including the second light emitting pattern layer ELP2, the second electrode pattern layer CEP2, and the second capping pattern layer CPP2 is disposed at each of the banks of the bank structure BNS and a stacked pattern layer including the second light emitting layer EL2, the second common electrode CE2 and the second capping layer CAP2 at light emission areas other than the second emission area EA2, are exposed to outside the second inorganic pattern and the second auxiliary pattern.

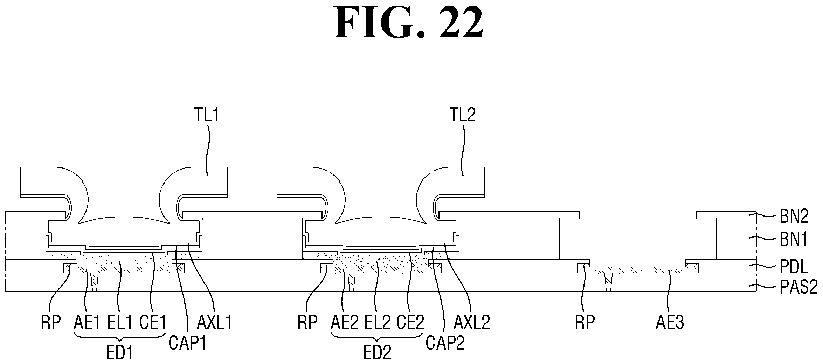

Next, as illustrated in FIG. 22, the second capping pattern layer CPP2, the second electrode pattern layer CEP2, and the second light emitting pattern layer ELP2 may be removed. That is, the stacked pattern layers discussed above which are exposed to outside the second inorganic pattern and the second auxiliary pattern are removed. This process may proceed similarly to FIG. 18. The second inorganic layer TL2 as a second inorganic pattern and the second auxiliary layer AXL2 as a second auxiliary pattern overlapping the second emission area EA2 may be obtained.

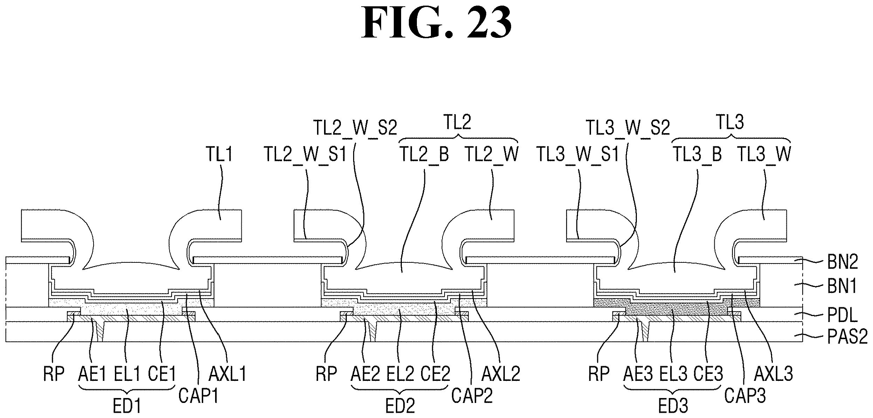

Thereafter, when the processes as illustrated in FIGS. 19 to 22 are similarly performed, the third light emitting element ED3 and the third inorganic layer TL3 may be formed at the third emission area EA3, as illustrated in FIG. 23.

Subsequently, although not illustrated in the drawings, the display device 10 is fabricated by forming the organic encapsulation layer TFE2 and the upper inorganic encapsulation layer TFE3 of the thin film encapsulation layer TFEL, on the stacked structure of FIG 23, and providing the light blocking layer BM, the color filter layer CFL and the overcoat layer OC on the light emitting elements ED1, ED2, and ED3 and the bank structure BNS. Structures of the thin film encapsulation layer TFEL, the light blocking layer BM, the color filter layer CFL, and the overcoat layer OC are the same as those described above, and a detailed description thereof will thus be omitted.

In an embodiment, the display device 10 includes a pixel electrode in a light emission area, a pixel defining film PDL (or pixel defining layer) which is on the pixel electrode and defines the light emission area, a light emitting layer and a common electrode on the pixel electrode, a bank (e.g., the bank structure BNS) on the pixel defining film PDL, the bank including a first bank layer BN1 comprising a side surface defining a lower portion of a bank opening corresponding to the light emission area and a second bank layer BN2 on the first bank layer BN1, the second bank layer BN2 comprising a side surface which defines an upper portion of the bank opening and a tip TIP of the bank, the tip including upper and lower surfaces of the second bank layer BN2, a lower inorganic encapsulation layer (e.g., TL1 and TL2 together) which is on the bank and includes an inorganic pattern (e.g., TL1) on the common electrode and facing and spaced apart from both the upper and lower surfaces of the tip TIP, and an auxiliary pattern (e.g., AXL1) between the lower surface of the tip TIP and the inorganic pattern (e.g., TL1).

The auxiliary pattern may extend from the lower surface of the tip TIP, along the side surface of the first bank layer BN1 and along the common electrode (refer to FIGS. 5 through 8). A thickness portion of the auxiliary pattern which extends along the common electrode (e.g., first thickness d1) and a thickness portion of the auxiliary pattern which extends along the lower surface of the second bank layer (e.g., second thickness d2) may be different from each other.

The auxiliary pattern may extend from the lower surface of the tip TIP and along the second surface of the inorganic pattern (refer to FIG. 7, for example). The auxiliary pattern may further extend from the second surface of the inorganic pattern and along the first surface of the inorganic pattern (refer to FIGS. 5 and 6, for example). A thickness portion of the auxiliary pattern which extends along the first surface of the inorganic pattern (e.g., the third thickness d3) may be greater than a thickness portion of the auxiliary pattern which extends along the lower surface of the tip TIP.

The tip TIP of the second bank layer may overlap the light emitting layer and may be in contact with the organic encapsulation layer. Opposing ends of the common electrode may be in the bank opening and overlap the tip TIP.

In an embodiment, the pixel electrode and the light emission area may be provided in plural including a first pixel electrode AE1 in a first light emission area EA1 and a second pixel electrode AE2 which is spaced apart from the first pixel electrode AE1 and in a second light emission area EA2, the light emitting layer and the common electrode may be provided in plural including a first light emitting layer EL1 and a first common electrode CE1 which are on the first pixel electrode AE1, and a second light emitting layer EL2 spaced apart from the first light emitting layer EL 1 and a second common electrode CE2 spaced apart from the first common electrode CE1, the second light emitting layer EL2 and the second common electrode CE2 being on the second pixel electrode AE2, the bank opening may be provided in plural including a first bank opening corresponding to the first light emission area EA1 and a second bank opening corresponding to the second light emission area EA2, the tip TIP may be provided in plural, the inorganic pattern may be provided in plural including inorganic patterns (e.g., TL1 and TL2) respectively on the first common electrode CE1 and on the second common electrode CE2, and the auxiliary pattern provided in plural including auxiliary patterns (e.g., AXL1 and AXL2) and respectively between the lower surfaces of the tips TIP and the inorganic patterns.

The display device 10 includes a lower inorganic layer TFE1 of an encapsulation layer TFEL on the bank, the lower inorganic layer including an inorganic pattern including a body portion on the common electrode and a wing portion which extends from the body portion, the wing portion facing and spaced apart from both the upper surface and the lower surface of the tip, an auxiliary pattern between the common electrode and the body portion of the inorganic pattern, and an organic encapsulation layer of the encapsulation layer between the wing portion of the inorganic pattern and the tip.

A method of providing a display device includes preparing a first stacked structure on a substrate SUB (FIG. 14, for example), the first stacked structure including pixel electrodes spaced apart from each other and respectively in light emission areas, a pixel defining layer which is on the pixel electrodes and defines the light emission areas at which the pixel electrodes are exposed to outside the pixel defining layer, a first bank layer of a bank, on the pixel defining layer, the first bank layer including side surfaces defining lower portions of bank openings respectively corresponding to the light emission areas, and a second bank layer of the bank, on the first bank layer, the second bank layer including side surfaces defining upper portions of the bank openings, the side surfaces of the second bank layer protruding further than the side surfaces of the first bank layer to define tips of the bank, and the tips including upper surfaces of the second bank layer and lower surfaces of the second bank layer which are respectively opposite to the upper surfaces.

The method further includes providing a first light emitting material layer on the first stacked structure, the first light emitting layer including a first light emitting layer on a first pixel electrode of the pixel electrodes and a first light emitting pattern layer on the second bank layer, and providing a first common electrode material layer on the first light emitting material layer, the first common electrode material layer including a first common electrode on the first light emitting layer and a first electrode pattern layer on the first light emitting pattern layer (FIG. 15, for example), and providing a first auxiliary material layer (AXLL1 in FIG. 15) on the first common electrode material layer, the first auxiliary material layer extended from the first common electrode, along the lower surfaces of first tips of the bank which are adjacent to the first common electrode and along the first electrode pattern layer, providing a first inorganic material layer (TLL1 in FIG. 150) of a lower inorganic encapsulation layer along an entirety of the first auxiliary material layer.

The method further includes etching the first inorganic material layer to provide a first inorganic pattern (TL1 in FIG. 16) of the lower inorganic encapsulation layer, the first inorganic pattern overlapping the first common electrode and overlapping the first tips of the bank, together with exposing a portion of the first auxiliary material layer at areas except for the first inorganic pattern, etching the portion of the first auxiliary material layer to provide a first auxiliary pattern (AXL1 in FIG. 17) between the first inorganic pattern and the first tips of the bank, and exposing the second bank layer (BN2 in FIG. 18) by etching the first light emitting pattern layer and the first electrode pattern layer.

The exposing of the second bank layer (FIG. 18) may remove the first light emitting pattern layer and the first electrode pattern layer which are respectively between the first inorganic pattern and the upper surfaces of the first tips, to expose the upper surfaces of the first tips to outside the first auxiliary pattern.

The providing of the first light emitting layer on the first pixel electrode and the first light emitting pattern layer on the second bank layer includes disconnection of the first light emitting material layer by the first tips to separate the first light emitting material layer into the first light emitting layer and the first light emitting pattern layer (FIG. 15, for example).

For a second stacked structure including the first inorganic pattern and the first auxiliary pattern together with the second bank layer which is exposed (structure of FIG. 18), the method may further include providing a second light emitting material layer on the second stacked structure, the second light emitting material layer including a second light emitting layer on a second pixel electrode of the pixel electrodes and a second light emitting pattern layer on the second bank layer and on pixel electrodes of the pixel electrodes other than the second pixel electrode (FIG. 19) providing a second common electrode material layer on the second light emitting layer and including a second common electrode on the second light emitting layer and a second electrode pattern layer on the second light emitting pattern layer (FIG. 19), providing a second auxiliary material layer (AXLL1 in FIG. 19) on the second common electrode material layer, the second auxiliary material layer extended from the second common electrode, along the lower surfaces of second tips of the second bank layer which are adjacent to the second common electrode and along the second electrode pattern layer, providing a second inorganic material layer (TLL2 in FIG. 19) along an entirety of the second auxiliary material layer, and etching the second inorganic material layer to provide a second inorganic pattern (TL2 in FIG. 16) of the lower inorganic encapsulation layer, the second inorganic pattern overlapping the second common electrode and overlapping the second tips of the second bank layer, together with exposing a portion of the second auxiliary material layer at areas except for the second inorganic pattern (FIG. 16). The providing of the second light emitting layer on the second pixel electrode and the second light emitting pattern layer on the second bank layer includes disconnection of the second light emitting material layer by the second tips to separate the second light emitting material layer into the second light emitting layer and the second light emitting pattern layer.

## Claims

1. A display device comprising:
a pixel electrode in a light emission area;
a pixel defining layer which is on the pixel electrode and defines the light emission area;
a light emitting layer and a common electrode on the pixel electrode;
a bank on the pixel defining layer, the bank comprising:
a first bank layer comprising a side surface defining a lower portion of a bank opening corresponding to the light emission area; and
a second bank layer on the first bank layer, the second bank layer comprising:
a side surface defining an upper portion of the bank opening,
the side surface of the second bank layer protruding further than the side surface of the first bank layer to define a tip of the bank, and
the tip including an upper surface of the second bank layer and a lower
surface of the second bank layer which is opposite to the upper surface;
a lower inorganic layer of an encapsulation layer on the bank, the lower inorganic layer comprising an inorganic pattern which is on the common electrode, the inorganic pattern facing and spaced apart from both the upper surface and the lower surface of the tip; and
an auxiliary pattern between the lower surface of the tip and the inorganic pattern.

2. The display device of claim 1, wherein the auxiliary pattern extends from the lower surface of the tip, along the side surface of the first bank layer and along the common electrode.

3. The display device of claim 2, wherein a thickness portion of the auxiliary pattern which extends along the common electrode and a thickness portion of the auxiliary pattern which extends along the lower surface of the second bank layer are different from each other.

4. The display device of any one of claims 1 to 3, further comprising an organic encapsulation layer of the encapsulation layer which is between the upper surface of the tip and the inorganic pattern.

5. The display device of any one of claims 1 to 4, wherein the inorganic pattern includes a first surface facing the upper surface of the tip and a second surface facing the side surface of the second bank layer.

6. The display device of claim 5, wherein the auxiliary pattern extends from the lower surface of the tip and along the second surface of the inorganic pattern.

7. The display device of claim 6, wherein the auxiliary pattern further extends from the second surface of the inorganic pattern and along the first surface of the inorganic pattern, optionally wherein a thickness portion of the auxiliary pattern which extends along the first surface of the inorganic pattern is greater than a thickness portion of the auxiliary pattern which extends along the lower surface of the tip.

8. The display device of any one of claims 4 to 7, wherein the tip of the second bank layer overlaps the light emitting layer and is in contact with the organic encapsulation layer.

9. The display device of any one of claims 1 to 8, wherein:
(i) the auxiliary pattern includes transparent conductive oxide; and/or
(ii) opposing ends of the common electrode are in the bank opening and overlap the tip.

10. The display device of any one of claims 1 to 9, further comprising:
the pixel electrode and the light emission area provided in plural including a first pixel electrode in a first light emission area and a second pixel electrode which is spaced apart from the first pixel electrode and in a second light emission area;
the light emitting layer and the common electrode provided in plural including a first light emitting layer and a first common electrode which are on the first pixel electrode, and a second light emitting layer spaced apart from the first light emitting layer and a second common electrode spaced apart from the first common electrode, the second light emitting layer and the second common electrode being on the second pixel electrode;
the bank opening provided in plural including a first bank opening corresponding to the first light emission area and a second bank opening corresponding to the second light emission area;
the tip provided in plural;
the inorganic pattern provided in plural including inorganic patterns respectively on the first common electrode and on the second common electrode; and
the auxiliary pattern provided in plural including auxiliary patterns respectively between the lower surfaces of the tips and the inorganic patterns.

11. The display device of claim 1, wherein:
the inorganic pattern includes a body portion on the common electrode and a wing portion which extends from the body portion, the wing portion facing and spaced apart from both the upper surface and the lower surface of the tip;
the auxiliary pattern is between the common electrode and the body portion of the inorganic pattern; and
the encapsulation layer comprises an organic encapsulation layer, and the organic encapsulation layer of the encapsulation layer is between the wing portion of the inorganic pattern and the tip.

12. The display device of claim 11, wherein:
(i) the auxiliary pattern extends from the common electrode, along the lower surface of the tip and along the side surface of the first bank layer; and/or
(ii) the upper surface of the tip which faces the wing portion of the inorganic pattern is in contact with the organic encapsulation layer.

13. A method for providing a display device, the method comprising:
preparing a first stacked structure on a substrate, the first stacked structure including:
pixel electrodes spaced apart from each other and respectively in light emission areas,
a pixel defining layer which is on the pixel electrodes and defines the light emission areas at which the pixel electrodes are exposed to outside the pixel defining layer,
a first bank layer of a bank, on the pixel defining layer, the first bank layer comprising side surfaces defining lower portions of bank openings respectively corresponding to the light emission areas, and
a second bank layer of the bank, on the first bank layer, the second bank layer comprising:
side surfaces defining upper portions of the bank openings,
the side surfaces of the second bank layer protruding further than the side surfaces of the first bank layer to define tips of the bank, and
the tips including upper surfaces of the second bank layer and lower surfaces of the second bank layer which are respectively opposite to the upper surfaces;
providing a first light emitting material layer on the first stacked structure, the first light emitting material layer including a first light emitting layer on a first pixel electrode of the pixel electrodes and a first light emitting pattern layer on the second bank layer;
providing a first common electrode material layer on the first light emitting material layer, the first common electrode material layer including a first common electrode on the first light emitting layer and a first electrode pattern layer on the first light emitting pattern layer;
providing a first auxiliary material layer on the first common electrode material layer, the first auxiliary material layer extended from the first common electrode, along the lower surfaces of first tips of the bank which are adjacent to the first common electrode and along the first electrode pattern layer;
providing a first inorganic material layer of a lower inorganic encapsulation layer along an entirety of the first auxiliary material layer;
etching the first inorganic material layer to provide a first inorganic pattern of the lower inorganic encapsulation layer, the first inorganic pattern overlapping the first common electrode and overlapping the first tips of the bank, together with exposing a portion of the first auxiliary material layer at areas except for the first inorganic pattern;
etching the portion of the first auxiliary material layer to provide a first auxiliary pattern between the first inorganic pattern and the first tips of the bank; and
exposing the second bank layer by etching the first light emitting pattern layer and the first electrode pattern layer.

14. The method of claim 13, wherein:
(i) the etching of the first inorganic material layer comprises a dry etching process, and the etching of the first auxiliary material layer comprises a wet etching process; and/or
(ii) the exposing of the second bank layer removes the first light emitting pattern layer and the first electrode pattern layer which are respectively between the first inorganic pattern and the upper surfaces of the first tips, to expose the upper surfaces of the first tips to outside the first auxiliary pattern; and/or
(iii) the providing of the first light emitting layer on the first pixel electrode and the first light emitting pattern layer on the second bank layer comprises disconnection of the first light emitting material layer by the first tips to separate the first light emitting material layer into the first light emitting layer and the first light emitting pattern layer.

15. The method of claim 13 or claim 14, wherein a second stacked structure includes on the substrate, the first inorganic pattern and the first auxiliary pattern together with the second bank layer which is exposed,
the method further comprising:
providing a second light emitting material layer on the second stacked structure, the second light emitting material layer including a second light emitting layer on a second pixel electrode of the pixel electrodes and a second light emitting pattern layer on the second bank layer and on pixel electrodes of the pixel electrodes other than the second pixel electrode;
providing a second common electrode material layer on the second light emitting layer and including a second common electrode on the second light emitting layer and a second electrode pattern layer on the second light emitting pattern layer;
providing a second auxiliary material layer on the second common electrode material layer, the second auxiliary material layer extended from the second common electrode, along the lower surfaces of second tips of the second bank layer which are adjacent to the second common electrode and along the second electrode pattern layer;
providing a second inorganic material layer along an entirety of the second auxiliary material layer; and
etching the second inorganic material layer to provide a second inorganic pattern of the lower inorganic encapsulation layer, the second inorganic pattern overlapping the second common electrode and overlapping the second tips of the second bank layer, together with exposing a portion of the second auxiliary material layer at areas except for the second inorganic pattern,
wherein the providing of the second light emitting layer on the second pixel electrode and the second light emitting pattern layer on the second bank layer comprises disconnection of the second light emitting material layer by the second tips to separate the second light emitting material layer into the second light emitting layer and the second light emitting pattern layer.
